# FASCICULE DE BREVET EUROPEEN

(11) **EP 4 189 411 B1**
(45) Date de publication et mention de la délivrance du brevet: **10.09.2025**
(21) Numéro de dépôt: 21751523.8
(22) Date de dépôt: 23.07.2021
(51) Int. Cl.: G01R 31/396, H02J 7/00

(54) **SYSTÈME DE GESTION DE BATTERIES D'ACCUMULATEURS SEMI MODULAIRE**
SYSTEM ZUR VERWALTUNG EINER HALBMODULAREN AKKUMULATORBATTERIE
SEMI-MODULAR ACCUMULATOR BATTERY MANAGEMENT SYSTEM

(30) Priorité: 27.07.2020 FR 2007907
(43) Date de publication de la demande: 07.06.2023
(73) Titulaire: Limatech, 31300 Toulouse (FR)
(72) Inventeur: POUYADOU, Luc, 31190 BRIGNOUD (FR); DI MEGLIO, Maxime, 31650 SAINT ORENS (FR); ROBIN, Florence, 31650 SAINT ORENS (FR)
(74) Mandataire: AtlantIP International
(86) Numéro de dépôt international: PCT/EP2021/070673
(87) Numéro de publication internationale: WO 2022/023203

(56) Documents cités:
- EP-A1- 2 562 555
- WO-A1-2015/073638
- US-A1- 2007 182 371
- US-A1- 2018 026 456

## Description

### DOMAINE TECHNIQUE DE L'INVENTION

La présente invention concerne de manière générale le domaine des batteries d'accumulateurs, en particulier les batteries d'accumulateurs au lithium.

### ETAT DE LA TECHNIQUE ANTERIEURE

Les batteries d'accumulateurs sont constituées d'éléments électrochimiques qui peuvent être connecté en série ou en parallèle pour obtenir la tension et le courant nécessaire. Une batterie au lithium qui a subi des dépassements de ses paramètres de fonctionnement nominaux peut « sembler » fonctionner correctement, mais présenter un risque de surchauffe ou de feu.

Les batteries au lithium nécessitent donc des circuits de protection. Généralement, ces circuits assurent une mesure de la tension, du courant et de la température, et pilotent un organe de limitation du courant et de coupure.

En cas de court-circuit ou de surintensité, il est nécessaire de déconnecter la batterie pour éviter de l'endommager et éviter un échauffement excessif de la batterie ou de ses câbles de connexion.

Généralement, on utilise des disjoncteurs électromécaniques ou des fusibles, ou des circuits électroniques qui assurent une mesure du courant et pilotent un organe de coupure. Cependant, la mesure d'un courant n'est pas simple.

Il existe plusieurs méthodes de mesures de courant (shunt, mesure magnétique ou par un effet thermique). Néanmoins celles-ci peuvent impliquer une consommation élevée, ce qui peut nécessiter de recourir à un mode « veille » et un mode « actif ». Cela est difficilement compatible avec une protection court-circuit, celui-ci pouvant intervenir à tout instant.

En outre, une batterie de démarrage de moteur thermique doit fournir un très fort courant pendant quelques secondes à quelques dizaines de secondes. Aussi, le courant du disjoncteur devra être réglé à une valeur assez forte, de l'ordre de la moitié du courant de court-circuit (la puissance maximale fournie est atteinte quand la tension vaut la moitié de la tension à vide, et le courant la moitié du courant de court-circuit).

Avec le vieillissement, ou pour des températures basses, la résistance interne des éléments de batterie augmente, ainsi le courant de court-circuit diminue. Il est possible que ce courant devienne inférieur au courant de disjonction. Dans ce cas, la protection n'est plus assurée. Un mauvais usage peut entrainer une décharge complète de la batterie dans sa résistance interne, provoquant un fort échauffement, puis un incendie.

Enfin, par exemple et de manière non-limitative, une batterie non modulaire de 17 Ah peut fournir un courant de court-circuit de plus de 2000 A. Ainsi, un dispositif de coupure doit pouvoir supporter ce courant. Des semi-conducteurs pouvant supporter ce courant ne sont pas fréquents et en pratique, plusieurs composants de plus faible courant sont connectés en parallèle. L'équilibre des courants est très difficile à réaliser, ce qui impose de sur-dimensionner les composants. La mesure d'un courant 2000 A pose aussi des problèmes de compromis entre la précision et la consommation statique.

Plusieurs dispositifs ont été proposés afin de sécuriser les batteries et notamment surveiller leur état, et le cas échéant, provoquer la coupure du circuit électronique, notamment lors de court-circuits.

En outre, ces systèmes doivent ainsi présenter un moyen de surveillance et un moyen de coupure ou d'ouverture du circuit. Plusieurs mécanismes différents existent, avec leurs avantages et leurs défauts.

Plusieurs systèmes comprennent un système de gestion de batteries (BMS) plus ou moins sophistiqué permettant de suivre l'état d'une batterie, d'accumulateurs d'une batterie et/ou d'agir sur le circuit de la batterie pour l'ouvrir en cas de problème.

Ainsi, le document EP2092627 propose un système de gestion de batteries (BMS) comprenant deux entrées et une sortie de courant. Le document enseigne l'utilisation d'un shunt lorsque la batterie est complètement chargée. Les accumulateurs sont disposés en série avec un dispositif de coupure pour réaliser la coupure en cas de court-circuit. Le BMS mesure la tension, la température à chaque accumulateur disposé en série. Des accumulateurs peuvent être ajoutées à la suite les uns des autres afin d'augmenter la tension délivrée, et l'augmentation du courant doit être suivie par un redimensionnement des composants. Le BMS est chargé, à chaque point, de mesurer l'équilibre de chaque accumulateur afin d'équilibrer la batterie. Autrement dit, on a l'équivalent d'un BMS par cellule. Ce document propose enfin de placer un MOSFET (« Charge control ») entre l'entrée (borne +) et les accumulateurs, et un autre MOSFET (« Discharge Control ») entre la sortie (Borne -) et les accumulateurs.

Le document CN110265738 propose un système différent de contrôle de groupe de cellules lithium, qui surveille la température, le courant et la tension de parties du circuit. Il permet ainsi la détection/protection contre la surintensité ainsi que la limitation du courant de charge.

Le BMS des batteries True Blue Power compte un très grand nombre de composants, de nombreuses cartes électroniques, et de nombreux connecteurs. Cela pénalise les coûts et la fiabilité. Le BMS possède 2 modes de fonctionnement, « veille et actif » et une microcoupure toutes les heures est observée en mode veille. L'organe de coupure comporte plusieurs MOSFETs en parallèle. Une telle solution comporte des problèmes d'équilibre des courants dans les différents MOSFETs, nécessite des composants de puissance qui doivent être surdimensionnés, enfin la mesure de courant entraîne une forte consommation du dispositif de mesure de courant et donc une autodécharge importante.

Il existe également des dispositifs de gestions de batteries complexes tels que celui enseigné dans la demande de brevet WO 2018095039 A1, qui décrit un système de gestion de batterie intelligent à distance, comprenant : au moins deux blocs de batterie, un centre d'analyse de données et un moniteur de terminal. Chaque bloc de piles est équipé d'un ensemble de piles au lithium, d'un module de système de gestion des piles (BMS), d'un module de communication GPS et d'un module de communication 4G. Le module BMS est utilisé pour obtenir les données du jeu de batteries au lithium et pour gérer le jeu de batteries au lithium ; le module GPS est utilisé pour obtenir les données de localisation des informations géographiques du jeu de batteries au lithium ; le module de communication 4G est utilisé pour transmettre les données du jeu de batteries au lithium et les données de localisation des informations géographiques au centre d'analyse des données au moyen d'une station de base ; le centre d'analyse des données est doté d'un centre de test des données, d'un centre de stockage des données et d'un centre d'analyse des batteries d'intelligence artificielle basé sur le Cloud. Le système de gestion de batteries intelligent à distance peut ajuster en temps réel une politique de gestion d'un BMS, et contrôler les conditions de charge et de décharge des ensembles de batteries au lithium, de sorte que la sécurité des batteries est grandement améliorée. En déterminant les conditions de fonctionnement des ensembles de batteries au lithium, les coûts de communication après-vente sont réduits, et le taux d'utilisation et le taux de réparation des ensembles de batteries au lithium sont améliorés.

Dans ce dispositif, l'organe de décision et mémorisation est déporté à l'extérieur de la batterie. Le module de gestion de piles sert uniquement à collecter les mesures et les envoyer à un centre d'analyse des données qui fait donc la détection d'anomalies et la décision de gestion des piles.

On connaît aussi le document EP2562555A1 qui décrit un bloc-batterie comprenant une pluralité d'unités de batterie connectées mutuellement en parallèle, chacune comprenant un groupe de cellules dans lequel une ou deux ou plusieurs cellules secondaires sont connectées en série, et un premier élément de commande de courant qui est connecté en série à ce groupe de cellules, un un premier moyen de commande qui contrôle le courant de charge/décharge pour chaque unité de batterie en commandant le fonctionnement du premier élément de commande de courant inclus dans chacune des unités de batterie ; un moyen de mesure de tension qui mesure la tension du ou des groupes de cellules inclus dans chacune des unités de batterie, et un moyen de diagnostic qui diagnostique un niveau de détérioration ou un défaut de chaque unité de batterie sur la base de la tension du ou des groupes de cellules mesurée par les moyens de mesure de tension.

On connait enfin le document US2018/026456A1 qui décrit un système de batterie comprenant une pluralité de modules de batterie connectés en parallèle. Chaque module de batterie comprend une batterie, une première borne de sortie et une seconde borne de sortie, un circuit de commutation connecté entre la batterie et la première borne de sortie, et un gestionnaire de batterie pour détecter une tension de batterie de la batterie et commander le circuit de commutation. Chaque gestionnaire de batterie est connecté à d'autres gestionnaires de batterie via un bus de communication et transmet des informations de module d'un module de batterie correspondant aux autres gestionnaires de batterie via le bus. Chaque gestionnaire de batterie reçoit également des informations de module provenant des autres gestionnaires de batterie via le bus et commande un circuit de commutation correspondant sur la base des informations de module.

Cependant, les solutions de l'art antérieur présentent des inconvénients car elles proposent des batteries d'accumulateurs difficilement modulables tout en conservant un bon équilibrage des différents accumulateurs et une bonne fiabilité et sécurité. De plus, les solutions proposées décrivent des architectures utilisant des éléments externes, voire distants, ce qui provoque la multiplication des câblages et/ou d'autres composants plutôt qu'une architecture simple et interne à la batterie.

### EXPOSE DE L'INVENTION

La présente invention a donc pour objet de proposer un système de gestion de batteries (BMS) d'accumulateurs semi modulaire, permettant de palier au moins une partie des inconvénients de l'art antérieur.

Ce but est atteint par un système de gestion de batteries (BMS) d'accumulateurs d'un élément semi modulaire tel que défini par la revendication indépendante 1. Des modes particuliers de réalisation de l'invention sont définis par les revendications dépendantes.

### BREVE DESCRIPTION DES FIGURES

D'autres caractéristiques, détails et avantages de l'invention ressortiront à la lecture de la description qui suit en référence aux figures annexées, qui illustre :
- [Fig. 1] représente un schéma fonctionnel du circuit de la batterie selon un mode particulier de réalisation
- [Fig. 2] représente un schéma structurel simplifié d'une partie du circuit de la batterie.
- [Fig. 3] représente un schéma d'une partie du circuit montrant la structure et le fonctionnement de l'organe de coupure à la décharge du dispositif de disjonction et son actionnement par l'ouverture d'un MOSFET, dans un mode de réalisation particulier.
- [Fig. 4] représente un schéma d'une partie du circuit montrant la structure et le fonctionnement de l'organe de coupure à la charge du dispositif de disjonction et son actionnement par un optocoupleur, dans un mode de réalisation particulier.
- [Fig. 5] représente une vue schématique de la batterie comprenant plusieurs lignes d'accumulateurs, fixés par des PCB dont le PCB top, la batterie comprenant en outre le BMS fixé.
- [Fig. 6] représente une vue de face en coupe de la batterie selon l'axe X-X' passant par une ligne d'accumulateurs.
- [Fig. 7] représente une vue schématique en coupe longitudinale passant par l'axe X-X' passant par une ligne d'accumulateurs.
- [Fig. 8] représente schématiquement le circuit le circuit des PCB haut et bas du bloc batterie.
- [Fig. 9] représente l'affichage des évolutions de la tension aux bornes des comparateurs U1 et U2 en cas de surintensité selon un mode de réalisation pour une batterie de 24,4 Volts et tension de déclenchement Td de 16 Volts
- [Fig. 10] représente la réponse d'un montage intégrateur numérique fonctionnant selon le logigramme de la figure 12 selon un mode de réalisation utilisé avec une batterie de 16 Volts et une tension de déclenchement Td de 12Volts ;
- [Fig. 11] représente la réponse d'un montage intégrateur analogique selon un autre mode de réalisation analogique utilisé avec une batterie de 16 Volts et une tension de déclenchement Td de 12 Volts et ;
- [Fig. 12] un logigramme explicitant le programme de calcul de la réponse d'un montage intégrateur numérique selon un mode de réalisation avec mise en parallèle des modes de réalisation analogiques ;

### DESCRIPTION DETAILLEE DE L'INVENTION

De nombreuses combinaisons peuvent être envisagées sans sortir du cadre de l'invention ; l'homme de métier choisira l'une ou l'autre en fonction des contraintes économiques, ergonomiques, dimensionnelles ou autres qu'il devra respecter.

De manière générale, la présente invention comporte un système de gestion de batteries (BMS) d'accumulateurs d'un élément semi modulaire comprenant une pluralité d'éléments cellulaires au lithium connectés en série pour former une ligne, et comprenant au moins deux lignes séries reliées en parallèle constituant l'élément semi modulaire, et au moins un circuit de détection caractérisé en ce que le circuit de détection comporte au moins un dispositif de détection de décharge ou de court-circuit et au moins un dispositif de surveillance de tension et de température d'un élément cellulaire ou modulaire, le circuit de détection commandant un dispositif de disjonction comprenant un organe de coupure par ligne.

Avantageusement, la batterie comprend au moins deux lignes d'éléments cellulaires en parallèle, chaque ligne possédant son organe de coupure. Le BMS, est lui aussi configuré pour effectuer des mesures sur chaque ligne d'éléments cellulaires formant des lignes d'accumulateurs afin de pouvoir couper du circuit un bloc défaillant indépendamment des autres. Cela permet notamment à la batterie de rester fonctionnelle, en délivrant un courant maximum inférieur mais sans que la tension de la batterie série-parallèle soit changée. Ainsi, la panne est évitée malgré la défaillance d"un ou d'une partie des accumulateurs de la batterie.

Dans certains modes de réalisation, le circuit de détection est relié d'une part au pôle négatif ou positif de chaque ensemble de cellules ou chaque batterie et d'autre part à la cosse négative respectivement positive de la batterie et utilise au moins deux, de préférence seulement deux, MOSFET M1, M2 par ligne; un premier MOSFET M1 effectuant une coupure du circuit en cas de décharge en dessous d'un seuil ou lors d'un court-circuit, un deuxième MOSFET M2 effectuant une coupure à la charge en cas de dépassement, de tension ou de température, d'un élément, dudit circuit, le circuit comprenant en outre des composants électroniques (diode, résistances, condensateur), par exemple autour du deuxième MOSFET M2 effectuant une limitation de courant à la charge, chaque ligne comprenant un organe de coupure à la charge, à la décharge, et limitant de courant à la charge.

La présence et l'utilisation de MOSFETs à chaque ligne d'accumulateurs comme organes de coupure à la charge et à la décharge permet avantageusement de couper du circuit spécifiquement la ligne défaillante.

La protection contre les courts-circuits, les surintensités et la décharge profonde permet de respecter les valeurs déterminées comme seuils. Le système de la présente invention actionne la disjonction de la batterie si la tension et la durée atteignent lesdites valeurs seuils. L'électronique embarque ainsi en outre un dispositif de limitation de courant de charge, et de protection en cas de défaillance de l'alternateur de l'appareil ou du chargeur.

On comprend bien que les composants permettant cette limitation à la charge ne sont pas sur le circuit de la décharge, mais sur le circuit/ligne de charge.

Dans certains modes de réalisation, le premier MOSFET (M1) est connecté par sa source à la borne négative d'un jeu de cellules, ce premier MOSFET (M1) reçoit sur sa grille une source de tension (V2) qui pilote (M1) cette source délivrant une tension choisie (par exemple 6 à 10 V) pour que le premier MOSFET (M1) soit passant, une diode Zener (D3) est branchée en opposition entre la grille et la source du premier MOSFET (M1) et un condensateur (C2) protègent la grille du premier MOSFET (M1) de tensions trop élevées ou haute fréquence et une diode zener (D1) montée en opposition entre la grille du premier MOSFET (M1) et le drain et en série avec une résistance (R3) et une diode (D2) en sens passant dans le sens drain grille, (D1, D2, R3) limitant la vitesse de commutation du premier MOSFET (M1) et un circuit constitué d'une diode Schottky (D4) limite le courant de charge, cette diode Schottky (D4) est montée en opposition sur le drain du premier MOSFET (M1) dans le sens de charge et en série avec un condensateur C1 et une résistance R1 reliés à la borne positive de la batterie pour permettre également de limiter la surtension à l'ouverture du premier MOSFET M1, en parallèle sur la diode Schottky (D4) est monté une résistance I1 reliée d'une part à la cathode de la diode et d'autre part au drain du deuxième MOSFET (M2) dont la source est relié à l'anode de la diode Schottky (D4), la grille du deuxième MOSFET (M2) étant commandée par une sortie du circuit de détection pour empêcher la charge.

Avantageusement ce montage permet de limiter la vitesse de commutation de M1, de limiter la surtension à l'ouverture de M1 et en outre de limiter le courant lors de la charge.

Dans certains modes de réalisation, le deuxième MOSFET M2 est branché par sa grille à la base du phototransistor d'un opto-coupleur dont l'émetteur est relié à la source de M2, entre ces deux points sont branchés une diode zener D5 et un condensateur C5, par la carte BMS, la diode électroluminescente de l'opto-coupleur est branchée par sa cathode à la borne négative de la batterie ou de l'ensemble modulaire de cellules et reçoit sur son anode la commande envoyant un courant dans la LED en cas de dépassement de tension ou de température d'un élément relevé.

Avantageusement, cette disposition permet la coupure du circuit ou d'une ligne du circuit sur décision du BMS, particulièrement en cas de dépassement de tension ou de température d'un élément relevé.

Dans certains modes de réalisation, l'agencement du circuit de disjonction associé aux deux MOSFETs est interposé entre le pôle de sortie d'une ligne et la même borne, de même polarité (positive ou négative) de la batterie.

Dans certains modes de réalisation, le BMS est connecté et contrôle chaque élément cellulaire et chaque ligne d'accumulateur du circuit et surveille la tension de chaque cellule et de chaque ligne série de cellules.

Cela permet avantageusement de sécuriser la batterie au niveau de l'accumulateur unitaire. En effet un accumulateur pourrait être en défaut et venir déséquilibrer les autres accus, menant à une faille de sécurité.

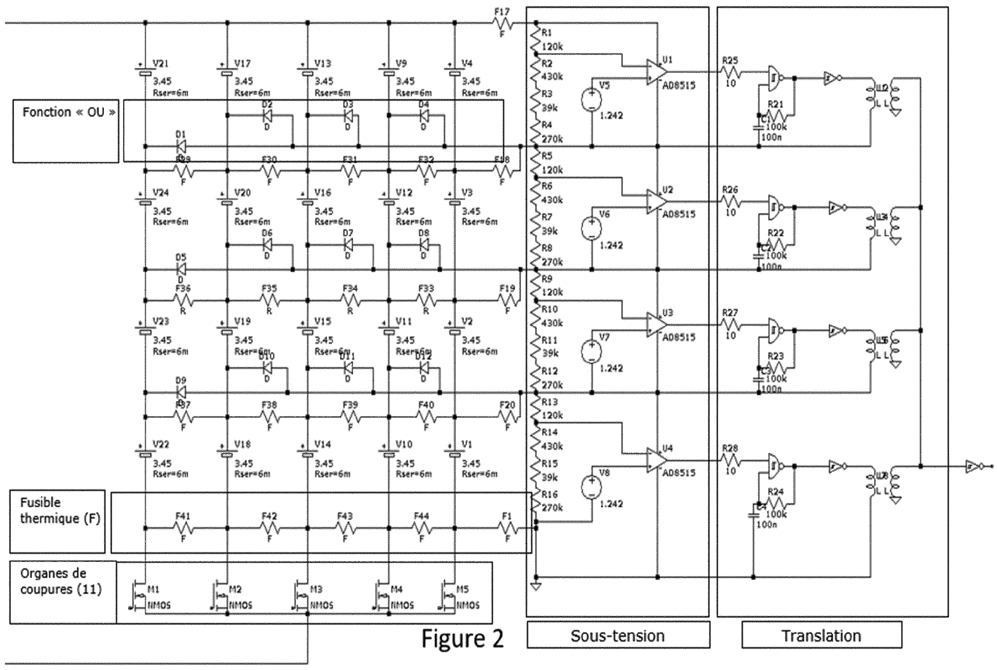

De préférence, le circuit ne comprend pas de shunt comme représenté dans la figure 2. Le principe est de prélever une proportion de la tension de chaque cellule ou de chaque ensemble parallèle de cellules. Sur la figure 2 chaque ensemble de cellules parallèles (V4,V9,V13, V17, V21) sont reliées d'une part chacune sur une polarité à la cathode d'une diode respective (D1, D2, D3, D4), chaque diode ayant comme point commun son anode pour réaliser une fonction OU et d'autre part par l'autre polarité avec une extrémité d' un pont diviseur (R1, R2, R3, R4) relié par son autre extrémité au point commun des anodes pour le premier ensemble de cellule montées en parallèle comme représenté en haut de la figure 2 dans le carré (sous-tension).La tension proportionnelle au OU des tensions de chaque cellule est utilisée, soit de façon analogique par un comparateur alimenté sur son autre borne par une tension de référence soit de façon numérique comme explicité ci-après.

Le principe de mesure via un montage intégrateur tel que décrit dans la présente demande est un principe de mesure d'une tension globale qui permet de remonter à une valeur de courant. Ce principe n'est valable dans le domaine de la batterie que lorsque l'on connait la résistance interne du générateur de tension. Dans ce cas et uniquement dans ce cas, on peut utiliser ledit montage intégrateur soit en analogique (tel que représenté sur la figure 2) soit en numérique.

Par exemple, et de manière non limitative, la réponse ou la sortie d'un intégrateur numérique peut être calculée de la manière suivante :

Soit une variation de la tension représentée par x= (-0.25*V_{globale} + 2.5)*pondération, où V_{globale} est une tension obtenue à partir de la tension de la batterie par l'utilisation d'un pont diviseur de tension (R1-R2 ou R9-R4) et pondération est une variable qui permet de changer la constante d'intégration. L'équation ci-dessus est modifiable suivant les accumulateurs utilisés.

La sortie ou réponse, y, de l'intégrateur numérique ayant pour forme générale y = Intégration(x), où Intrégration( ) représente le calcul intégral, peut être calculée en utilisant soit comme une première équation de progressivité consistant à prendre la valeur de x , ci-dessus définie, et de l'élever à une puissance paire (2, 4, 6, 8...), par exemple y = x². Une seconde équation de progressivité est donnée par y= Taux *(-In(x)), avec Taux, la constante d'intégration exprimée en seconde.

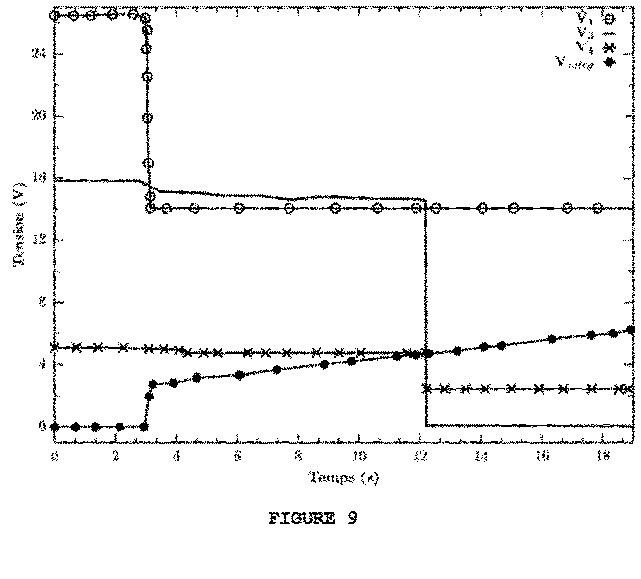

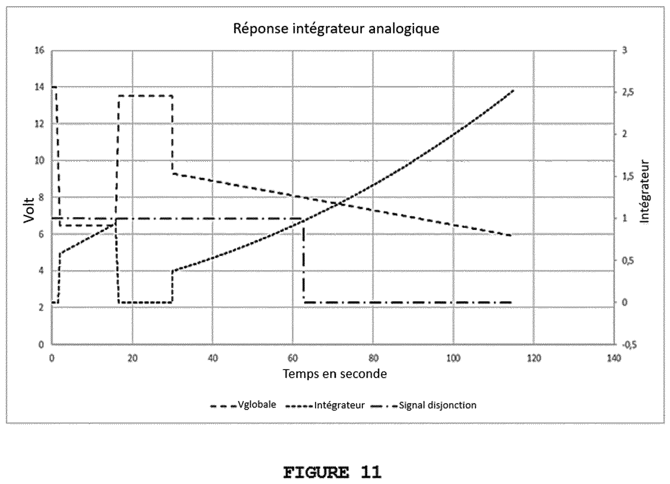

Pour se rapprocher encore plus de l'intégrateur analogique (figures 9, 11), une seconde équation de progressivité définie, par exemple et de manière non-limitative, par y= Taux *(-In(x)), avec Taux, une constante d'intégration exprimée en seconde, peut être utilisée. Cette équation permet d'imiter le comportement d'un condensateur dont la tension à ses bornes évolue comme une exponentielle.

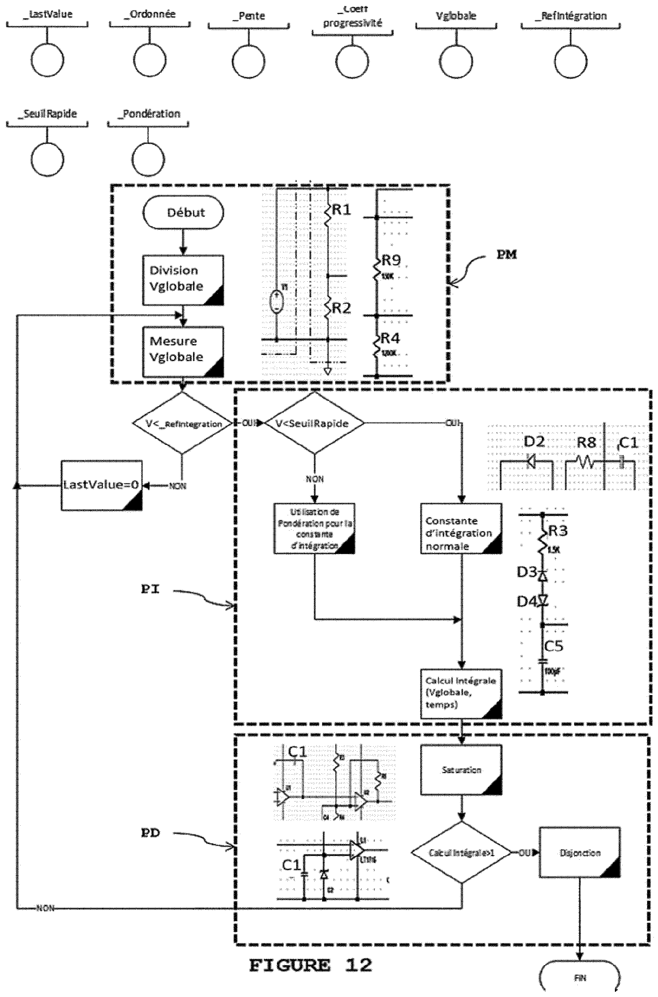

La figure 12 représente un diagramme de calcul de la réponse d'un intégrateur numérique selon la seconde équation de progressivité. Chaque étape de calcul représente les composants du dispositif de détection pouvant être impliqués dans les opérations de calcul. Le diagramme peut être divisé en trois phases: phase de mesure (PM) et comparaison, phase d'intégration (PI) et phase de disjonction (PD).

Dans la phase de mesure (PM), le pont diviseur de tension R1-R2 (ou R9-R4) permet de déterminer une mesure V=V_{globale} de la tension à l'entrée du dispositif de détection à partir de la tension V1 de la batterie.

La variable «Refintégration » est la référence d'intégration et correspond à une valeur de la tension en dessous de laquelle, le signal d'entrée V sera intégré. Si la tension V est supérieure à la variable « Refintégration », on se trouve dans une situation ou la batterie fonctionne normalement. Si V est inférieure à la variable « Refintégration », la batterie fonctionne anormalement et le processus pouvant conduire à la disjonction de ladite batterie est déclenché. Cette variable Refintégration est donc équivalente à la tension de référence V2 On entre alors dans la phase d'intégration où la réponse de l'intégrateur doit être calculée.

Dans le cas où la tension V est inférieure à la variable « Refintégration » le programme déclenche soit l'utilisation d'une constante normale d'intégration dans le calcul effectué, soit l'utilisation d'une pondération pour la constante d'intégration. Cette pondération comme représenté dans le cadre PI est utilisée si la tension est inférieure à une deuxième variable de comparaison appelée « SeuilRapide » qui permet de définir un seuil de tension à partir duquel la variable « pondération » (ci-dessus définie) est utilisée dans le calcul de la variation de la tension ou non. Par exemple, et de manière non-limitative, la variation de la tension a une forme générale de type x = (pente * V_{globale}+ ordonnée)*pondération.

Si la différence ou variation de la tension d'entrée V, dV, entre un instant t1 et un instant t2 (ou entre deux mesures successives de la tension V), définie par dV = |V(t2)-V(t1)|, est supérieure à la variable « SeuilRapide », la variable « pondération » prend par exemple la valeur 5. Si, au contraire, la dite différence ou variation de la tension V, dV, est inférieure à la variable « SeuilRapide », la variable « pondération » prend la valeur 1. Ce qui correspond à utiliser une constante d'intégration normale.

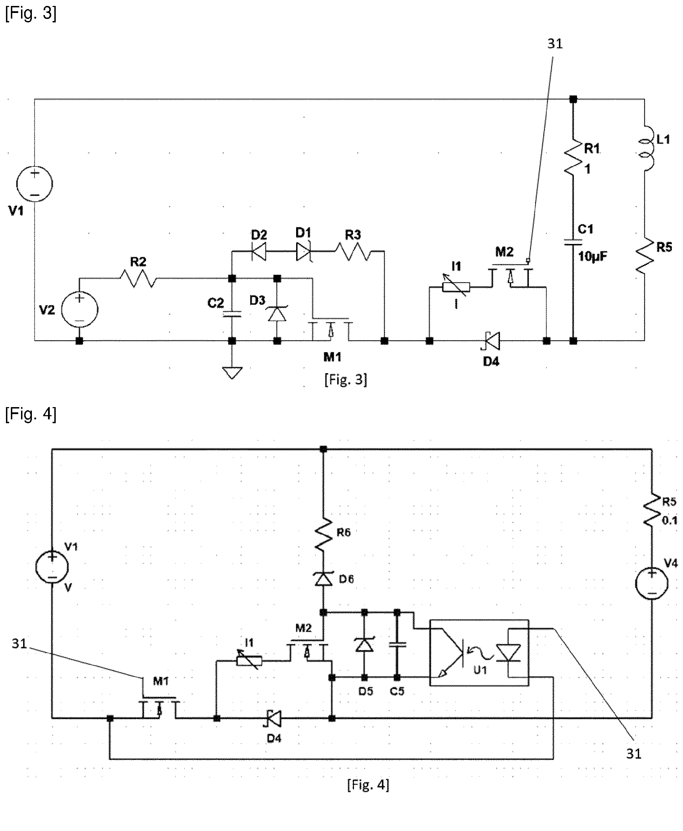

Le pas de temps de mesure de la tension peut être compris, par exemple et de manière non-limitative, entre 1ms à 100 ms. La valeur de la variable « SeuilRapide » peut être définie en fonction du pas de temps de mesure et en surveillant la variation de tension entre deux instants t1 et t2, correspondant au dit pas de temps, utilisé pour effectuer les mesures de tension, afin d'améliorer les conditions de détection de conditions anormales. Par exemple, et de manière non-limitative, pour la figure 4B, le pas de temps de mesure utilisé est de 10ms et la valeur de « SeuilRapide » est 0.01 Volt. Ce qui correspond à une chute de tension dV= 0.01 Volt toutes les 10ms.

Les variables « Ordonnée », « Pente», obtenues par mémorisation des points de mesure et calcul, par exemple par un fit des données mémorisées de la tension ou par l'utilisation de deux points de la courbe de tension mémorisée entre deux instants t1 et t2 pour déduire la « pente » (pour une variation linéaire de la tension) puis l' « ordonnée », permettent de définir la variation de tension. Dans l'exemple où x= (-0.25*Vglobale + 2.5)*pondération, la pente est -0.25 et l'ordonnée 2.5.

L'étape de comparaison de la variation de tension dV, équivaut à une étape de comparaison de la pente calculée avec la valeur « Seuilrapide » mémorisée soit, pour appliquer, en cas de dépassement par la pente de la valeur « Seuilrapide », un coefficient de pondération (par exemple 5) augmentant l'accélération de l'évolution de l'intégrale pour qu'elle franchisse plus vite le seuil Td de tension de déclenchement, soit en cas de non dépassement un coefficient de pondération sans effet d'accélération (par exemple 1).

Une fois que la variation de la tension est obtenue, le signal est intégré selon la seconde équation de progressivité par exemple. Le signal de sortie correspond ainsi à l'intégration du signal d'entrée.

La variable « Coeff progressivité » correspond à une constante d'intégration (Taux dans la seconde équation de progressivité).

Dans le mode de réalisation, par intégrateur numérique, l'homme de métier comprendra que le montage utilisant les comparateurs U1 et U2 est remplacé par un microprocesseur jouant le rôle d'un comparateur numérique (Un). Ledit microprocesseur est équipé d'une mémoire de stockage permettant la mémorisation des variables de seuil « Refintégration » et « SeuilRapide » et les variables de calcul « Ordonnée », « Pente» définies en fonction de ces seuils. La mémoire contient également le programme de calcul permettant permettant la collecte des points de courbe de tension (Vglobale, ...), les comparaisons et décisions, la mise en œuvre des équations, l'intégration et les décisions représentées dans le logigramme de la figure 12.

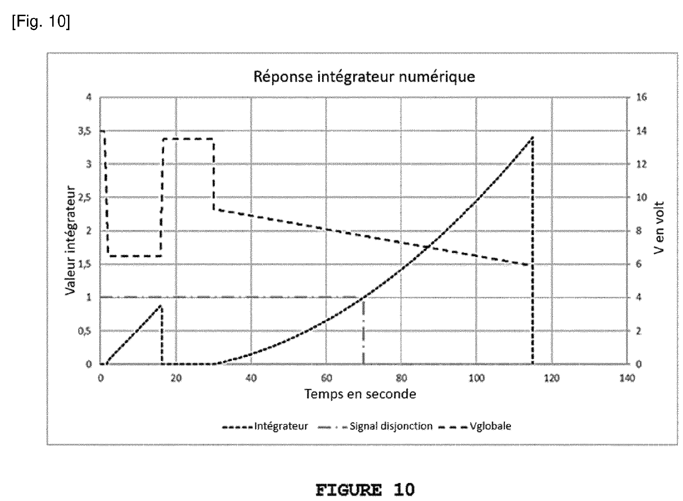

Le circuit numérique reçoit seulement en entrée la tension Vglobale provenant du point commun d'un pont diviseur entre une résistance R1 et une résistance R2 et effectue des mesures selon une fréquence déterminée pour observer la courbe de tension Vglobale, puis à partir de la détection du franchissement du seuil « Refintégration » qui, sur l'exemple de la figure 10 est choisi inférieur 3 Volts par élément cellulaire ou 12 volts pour une batterie de 4 éléments cellulaires en série à partir de cette Tension de référence V2 le programme du microprocesseur , déclenche les calculs pour obtenir la comparaison avec la variable « Seuilrapide » de la variation dV de la tension Vglobale entre deux instants successifs t1 et t2 (ou entre deux mesures successives), afin de déterminer l'utilisation ou non d'une variable « Pondération ». Ainsi dans le cas d'un démarrage entraînant une chute importante de la tension de 14 à presque 6 Volts, la valeur « seuil rapide » étant par exemple, et de manière non-limitative, fixée à 0.01 volt dans l'exemple de la figure 10, le seuil rapide sera franchi et l'intégration se fera avec une pondération pour éviter une coupure trop rapide empêchant le démarrage. Sur le diagramme de la figure 10 on peut observer que la tension batterie ayant chuté rapidement à presque 6 Volts et restant constante pendant environ 18 secondes, le circuit numérique intègre la valeur constante en une droite qui reste en dessous de la tension de détection ou déclenchement Td qui est choisie à 1 Volt. La réponse de l'intégrateur ou tension de sortie peut être, par exemple et de manière non-limitative, obtenue avec un programme tel que celui définie en annexe de la présente demande où la variable «tensionGenerale» correspond à la tension Vglobale à un instant t1 = t et, la variable «LastTensionGenerale» représente la valeur de la tension Vglobale à l'instant t2=t-1. La variable «ORDONNEE_ORIGINE» correspond à la variable «Ordonnée» définie ci-dessus et la variable «lastIntegratedValue» correspond au calcul intégral ou la réponse de l'intégrateur.

Le calcul de l'intégrale ou de la réponse de l'intégrateur peut comprendre la prise en compte des variables « Pente et/ou Ordonnée » calculées par le microprocesseur à partir des données de la courbe de tension Vglobale enregistrée.

L'intégration se déclenche dès que la tension globale Vglobale passe en dessous de V2= Refintégration= 9 Volts.

Ensuite au cours de son utilisation la tension de la batterie chute brutalement de 14 Volts à environ 9 Volts puis décroit lentement dans le temps selon une droite jusqu'à 6 volts. L'ordonnée de la droite est environ 2,3 volts et la pente est moins élevée que précédemment et la variation dV de la tension entre deux mesures successives peut être supérieure (en fonction de la valeur de la pente) à la variable « seuilrapide » (par exemple 0.01 volt dans l'exemple représenté figure 10).

Lorsque la valeur en sortie de l'intégration atteint le seuil correspondant à la tension de détection ou déclenchement Td de 1 volt, le déclenchement de la coupure est réalisé.

Enfin dans la version ou variante numérique, lors de court-circuit, la tension Vglobale chute très rapidement à une valeur très faible un seuil de détection de court circuit est mémorisé et dés que le processeur détecte le franchissement de ce seuil il active le signal de déclenchement de disjonction.

Dans la figure 10 illustrant la réponse ou signal de sortie d'un intégrateur numérique selon l'exemple décrit ci-dessus, l'intégrateur numérique présente un comportement qui se rapproche de celui d'un intégrateur analogique (figure 11) dans l'intervalle de temps compris entre t=40s et environ t=120 s.

Dans la phase de disjonction, le calcul de la réponse est utilisé pour vérifier si une disjonction doit être déclenchée (ou activée) ou pas. La disjonction est activée lorsque la réponse de l'intégrateur est supérieure à un seuil donné correspondant à la tension de détection ou déclenchement Td. Dans l'exemple ci-dessus, illustré par les figures 10, 11, 12, ce seuil est fixé à 1 ou 1,24 Volts environ. Par exemple et de manière non limitative, la valeur du seuil peut être normalisée à 1.

Ci-dessous est présenté un exemple, non-limitatif, de programme d'un intégrateur numérique pour implémenter la réponse de l'intégrateur de la figure 10 :

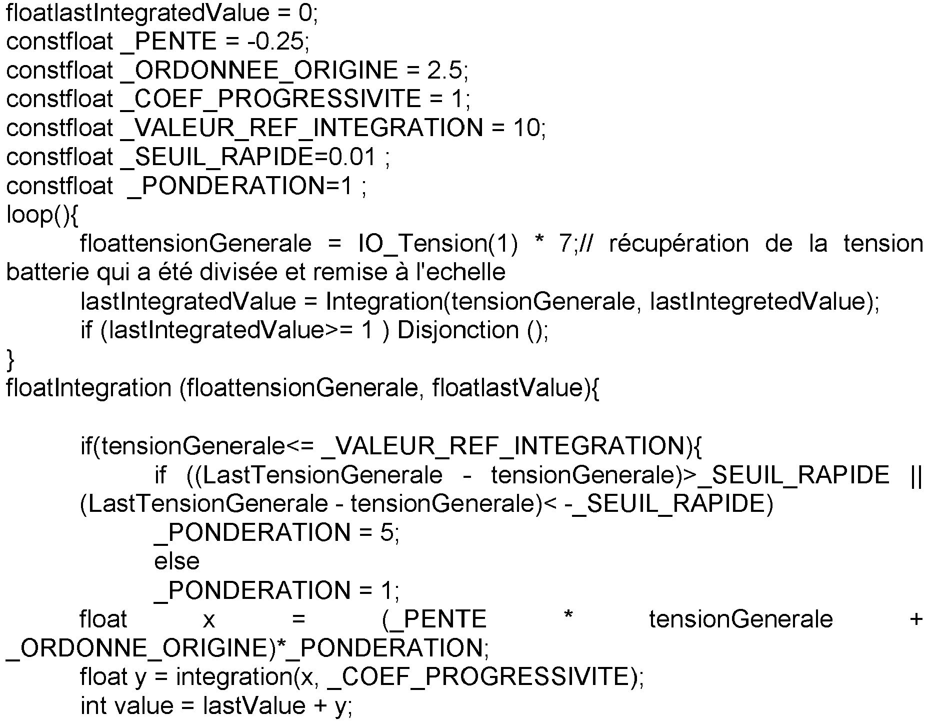

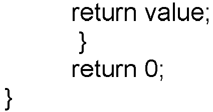

Ainsi le BMS comprend au moins un dispositif de détection (2) de décharges profondes, de surintensité et de court-circuit dans chaque élément unitaire ou ensemble modulaire de la batterie et comprend au moins un dispositif BMS; le BMS étant caractérisé en ce que le dispositif de détection est unique et comprend un comparateur U1 qui compare directement une tension proportionnelle, dans un rapport déterminé, à celle de l'élément unitaire ou de l'ensemble modulaire, sans utiliser un shunt résistif, pour la comparer à une tension de référence V2 pour activer ou non la disjonction de la batterie (4) en fonction des variations de la tension de l'élément unitaire ou de l'ensemble modulaire, le rapport de proportion entre la tension mesurée et celle de référence correspond au rapport entre la tension de référence V2 et la tension de déclenchement Td à partir de laquelle le dispositif de disjonction est actionné.

Dans une variante du BMS un microprocesseur équipé d'au moins une mémoire de stockage permettant la mémorisation d'au moins une variable de seuil « Refintégration » et d'une valeur de tension de détection mémorisée Td, la mémoire contenant également le programme exécuté par le microprocesseur permettant la collecte des points de courbe de tension Vglobale , les comparaisons des tensions Vglobale avec « refintégration » et de l'intégrale de tension calculée (Vinteg) avec Td et décisions, la mise en œuvre des équations permettant l'intégration, le microprocesseur recevant en entrée la tension Vglobale provenant du point commun d'un pont diviseur de résistances branché entre les deux pôles de la cellule ou de l'ensemble de cellules et mémorise les mesures selon une fréquence déterminée pour observer la courbe de tension Vglobale, et comparer les valeurs de la courbe de tension Vglobale à la valeur « Refintégration », puis à partir de la détection du franchissement du seuil « Refintégration » ,défini par la valeur mémorisée dans la mémoire, déclenche les calculs d'intégration de la courbe Vglobal et compare les valeurs de la courbe d'intégration (Vinteg) calculée à une valeur de tension de détection mémorisée Td pour activer le dispositif de disjonction effectuant la coupure.

Selon une variante la mémoire comporte également la valeur d'une variable « Seuilrapide » mémorisée pour déterminer par comparaison de la tension Vglobal instantanée avec le « Seuilrapide » si le calcul de l'intégrale de la courbe de tension Vglobal doit prendre en compte ou pas un coefficient de pondération.

Selon une autre variante le calcul de l'intégrale peut prendre en compte des variables « Pente et/ou Ordonnée » calculées par le microprocesseur à partir des données de la courbe de tension Vglobale enregistrée.

Dans certains modes de réalisation, le circuit de détection comporte une ou plusieurs des fonctionnalités suivantes :
- Equilibrage de la tension des cellules,
- Détection tension trop basse et ouverture du circuit
- Détection, par un circuit de mesure de tension, de court-circuit, de décharge profonde et de surintensité pour déclencher la disjonction d'un groupe de cellules par ouverture du circuit
- Détection tension trop haute d'une des cellules de la batterie et ouverture du circuit

Dans certains modes de réalisation, l'équilibrage de tension est réalisé par une fonction « OU » à diode reliant chacune des cellules montées en parallèle avec la polarité négative du pont diviseur du circuit de mesure de tension de court-circuit, décharge profonde et de surintensité.

Dans certains modes de réalisation, chaque élément cellulaire d'une ligne est relié à chaque élément cellulaire adjacent d'une autre ligne par un élément constituant un fusible thermique, de préférence réarmable.

Dans certains modes de réalisation, le circuit de détection comporte les fonctionnalités suivantes : intègre une surveillance de la température qui reste constamment active, même si la batterie est sur « off », en analysant la température dans l'enveloppe de la batterie, mesurée par une sonde montée sur la partie centrale 13 des cartes de chaque module.

Dans certains modes de réalisation, les composants électroniques du dispositif de disjonction limitant le courant à la charge, de préférence uniquement à la charge, pour la régulation du courant de charge comprennent un composant tel qu'une résistance, qui est passant dans un sens, et résistif, tel une diode montée en opposition, dans l'autre sens.

Dans certains modes de réalisation, le circuit est agencé de façon à ce que les organes de coupure à la charge et à la décharge sont pilotés indépendamment.

L'invention concerne aussi un bloc batterie à courant fort, semi-modulaire, série et parallèle constitué de cellules d'accumulateurs lithium de mêmes caractéristiques reliées en série pour former une ligne par des connexions selon une direction donnée S correspondant au sens des courants forts pour obtenir la tension nécessaire, et destiné à pouvoir être associé en parallèle avec une autre ligne de cellules d'accumulateurs, ledit bloc utilisant un système de gestion tel que décrit dans le présent exposé et caractérisé en ce que :
une paire de drageoirs supérieur 71 et inférieur 72 qui délimitent un ensemble de logement cylindriques à section carrée ou polygonale ou circulaire définissant selon la même direction S au moins une ligne de logements cylindriques à section carrée ou polygonale de maintien chacun d'une cellule d'accumulateur lithium ;
les connexions entre les cellules d'accumulateurs d'une même ligne selon la direction S sont assurées par des languettes larges (9) reliant sur chaque face supérieure ou inférieure du module chaque paire de cellules adjacentes montées en série par leur pôles de polarité opposées selon la première direction S, les languettes de connexion d'une face étant décalées d'une cellule sur l'autre face ;
les drageoirs comportent au moins deux lignes de logements parallèles à la direction S dans lesquelles au moins deux lignes de cellules sont disposées selon une direction perpendiculaire à S et reliées entre elles soit par des languettes fines jouant le rôle de fusible soit par des fusibles réarmables (F, fig.2), selon la direction perpendiculaire P à la direction S, chaque fusible reliant deux cellules appartenant à deux lignes parallèles différentes pour réaliser une connexion parallèle entre chaque cellule de deux ensembles parallèles de cellule série.

Dans certains modes de réalisation, le circuit est agencé de façon à ce que les organes de coupure à la charge et à la décharge sont pilotés indépendamment.

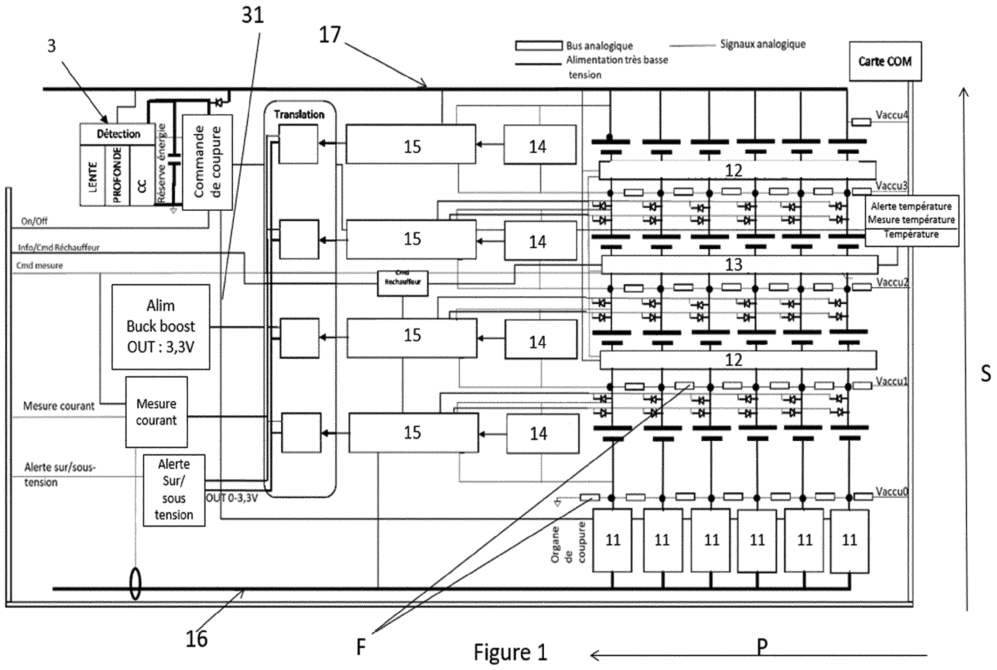

Dans certains modes de réalisation, les drageoirs maintiennent par les côtés à la partie supérieure 71 et inférieure 72 des cartes PCB (printed circuit board) en circuit imprimé comportant l'électronique et les liaison électrique entre les composants de l'électronique du système de gestion et les cellules du bloc semi-modulaire ;
des PCB intercalaires (12,13, fig 1) sont disposées verticalement entre les cellules selon une direction perpendiculaire à la direction S comportent au moins les résistances de réchauffement de l'ensemble semi -modulaire et ces résistances sont connectées sur commande du circuit de gestion à une alimentation ;
la partie PCB disposée sous les cellules contribue à la récupération des potentiels de chacune des cellules du bloc modulaire pour les fournir au circuit de gestion des tensions et de l'équilibrage du système de gestion du bloc modulaire.

On comprend que par « élément cellulaire », « cellule » ou « accumulateur », on entend tout système unitaire configuré pour stocker de l'énergie électrique sous une forme différente, ici de préférence par électrochimie par la technologie Lithium-ion.

Dans certains modes de réalisation, des résistances sont montés entre deux plages de contact (non représentées) sur les cartes PCB supérieure et/ou inférieure et le contact avec les cellules et les pistes du circuit imprimé supérieur ou inférieur sont réalisés par des broches élastiques (Pogo, ou des ressorts hélicoïdaux coniques, par exemple) disposées entre les cellules et la face conductrice comportant les plages de contact de la carte de circuit imprimé, évitant ainsi l'utilisation de soudure étain.

Avantageusement, la présente invention permet d'augmenter le courant par l'ajout de batteries en parallèle plutôt qu'en série sans problème d'équilibrage, et sans avoir besoin de redimensionner les éléments constitutifs du circuit (augmenter la capacité des accumulateurs et les tailles des transistors (organes de coupures). L'organe de coupure transistor, dans le cadre de cette solution, est adapté au courant de la ligne, ce qui permet un équilibrage aisé. En effet, dans certaines solutions, telles que TrueBlue Power, des blocs d'éléments cellulaires en parallèle sont disposés en série les uns après les autres avec un unique organe de coupure composé d'un certain nombre de MOSFEts disposés en parallèle les uns par rapport aux autres, si bien que le courant n'est pas équilibré. En effet, l'équilibre des courants de diodes ou d'organes de coupures en parallèle est quasi impossible à réaliser, du fait que la tension directe diminue fortement avec la température. Ainsi, l'élément le plus chaud supporte tout le courant, ce qui augmente encore sa température jusqu'à destruction. Ainsi, si un des organes de coupure chauffe plus, il va recevoir plus de courant et chauffer plus par effet d'avalanche, ce qui est à éviter à tout prix. A l'inverse la présente invention permet d'augmenter le courant et la capacité sans limite théorique, car la distribution du courant est la même dans tous les organes de coupure, qui n'ont donc pas besoin d'être surdimensionnés.

En d'autres termes, en dupliquant les éléments en parallèle il est important de garantir le bon fonctionnement de l'ensemble et notamment la surveillance de toutes les cellules. Plus le nombre de bloc en parallèle est augmenté, plus le nombre de connexions entre les cellules et les cartes est augmenté. L'utilisation des « pogo pin » (broches élastiques) ou des ressorts hélicoïdaux coniques limite le nombre de soudures tout en garantissant un assemblage facile par les drageoirs qui tiennent les cellules et les cartes PCB sur lesquelles une extrémité de chaque broche élastique est rendue solidaire mécaniquement du PCB et électriquement du conducteur de liaison. L'autre extrémité de la broche vient en contact avec un pôle de la cellule correspondant à l'emplacement du pogo.

En outre, la présente invention propose un organe de coupure par ligne d'éléments cellulaires afin de pouvoir ne couper que partiellement le circuit et ainsi permettre, au moins momentanément, l'utilisation de la batterie en sécurité malgré l'occurrence d'un problème (court-circuit, surcharge ou décharge profonde). On observe alors un maintien de la tension avec un courant disponible moins élevé.

De préférence, un seul organe de coupure est présent par ligne d'accumulateurs en série. Dans certains modes de réalisation, la tension globale par ligne de cellules et la tension de chaque cellule est surveillée par le BMS.

Dans certains modes de réalisation, la carte centrale verticale (13) comporte des sondes de températures et un thermostat.

Ainsi, dans certains modes de réalisation, la carte (5) comprenant le système de gestion (BMS) est disposée verticalement sur le côté du bloc batterie de façon à former un U avec les autres PCB dudit bloc.

Dans certains modes de réalisation, la carte centrale verticale comporte des sondes de températures et un thermostat.

Avantageusement, l'utilisation d'un optocoupleur permet entre autres la communication entre différents PCB.

Un exemple de procédé pour former un bloc batterie selon certains modes de réalisation tels que décrits ci-dessus comprend les étapes suivantes :
- pré soudage de blocs (2) (4 par 1 ou 8 par 1) d'accumulateurs (20) en série par les languettes (9),
- pose des blocs sur le drageoir bas (72) et sur le PCB bas (6),
- Pose du drageoir haut (71) et du PCB haut (4, 4'),
- Rivetage des accumulateurs sur la barre de puissance du PCB haut (4) [et rivetage du PCB haut (4) au drageoir haut (71), ce qui permet un montage facilité, plus rapide et avec une fiabilité et sécurité supplémentaire.

« Le contact entre les cellules (20) et les pistes de conducteurs reliant les cellules aux composant sont réalisés par les broches élastiques (10) ou ressorts hélicoïdaux coniques.

Dans certains modes de réalisation, comme par exemple illustré de manière non limitative à la figure 1 de manière fonctionnelle, un BMS (Battery Management System) est configuré pour mesurer la tension et le courant aux bornes des différents éléments cellulaires et la tension globale de chaque ligne, et mesurer la température au niveau de ces éléments cellulaires et/ou lignes. En fonction de la température mesurée, le BMS (3) peut envoyer un signal à des réchauffeurs configurés pour chauffer les éléments cellulaires afin de les maintenir à la température de fonction optimale. Lorsque que le BMS mesure une tension, ou un courant dépassant des valeurs-seuils prédéterminées, correspondant par exemple à une décharge lente ou profonde, à une surcharge ou à un court-circuit, il est configuré pour envoyer une commande de coupure à l'organe de coupure associé à la ligne d'accumulateurs comprenant l'élément cellulaire défaillant. Cela permet ainsi de couper une ligne sans couper le circuit entier. Cela permet notamment de continuer à faire fonctionner la batterie, dans un mode « dégradé » permettant de continuer à faire fonctionner, au moins pendant un certain temps, l'élément utilisant la batterie, par exemple un aéronef, sans endommager la batterie, jusqu'à ce que la batterie puisse être désactivée en toute sécurité, et réparée.

Avantageusement, une telle configuration permet la conception d'un circuit simplifié, avec une seule borne - et une seule borne +, plutôt que deux bornes +, en fonction de l'utilisation de la batterie (charge ou décharge) comme c'est le cas dans certains arts antérieurs.

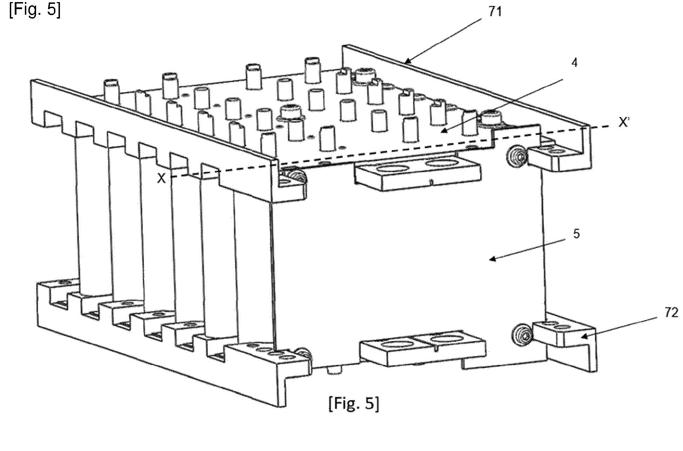

Plus particulièrement, la figure 2 illustre un exemple de mode de réalisation à titre d'exemple et non limitatif de la présente invention, dans lequel on embarque des fusibles réarmables entre les différents potentiels inter accu. Ce circuit est de préférence disposé sur le PBC haut (voir figure 5 à 7). Cela permet d'isoler un accumulateur défectueux (en court-circuit), car sinon cet accumulateur entrainerait des courants importants et pourrez aboutir à une destruction de la batterie. Avec des diodes sont réalisées des fonctions « ou » de toutes les lignes d'accumulateurs par potentiel, ainsi pour une batterie de par exemple 12 V nous obtenons 4 potentiels pour la tension basse et 4 potentiels pour la tension haute. Cette tension est alors comparée à un seuil pré déterminé et une coupure est réalisée en cas de dépassement de ces seuils. Il y a un circuit de sous tension et un circuit de surtension dont les détections se fond par mesure aux bornes de chaque accumulateur et sont concaténées à l'aide de diodes.

La tension d'alimentation des blocs sous/sur tension et équilibrage sont effectués directement aux bornes de l'accumulateur, on obtient un circuit alimenté entre 0-4V (0-4V, 4V-8V,8V-12V,12V-16V), ce qui pose un problème pour récupérer l'information de sortie. Il faut donc un étage d'adaptation afin de réaliser une translation de niveau. La sortie des comparateurs est couplée avec un transformateur d'impulsion en faisant osciller une porte logique à hystérésis.

Les figures 3 et 4 représentent le circuit de l'organe de coupure da façon simplifiée : certains éléments ne sont pas représentés (respectivement les composants liés à M2 dans la figure 3 et les composants liés à M1 dans la figure 4) afin de simplifier la lecture desdites figures.

Des transistors MOSFET sont utilisés pour les dispositifs de coupure. Cela permet avantageusement d'obtenir des organes de coupure présentant une très faible consommation statique aussi bien à l'état passant qu'à l'état bloqué. La figure 3 détaille de manière non limitative un exemple de coupure à la décharge à base de MOSFET. V1 est la batterie et L1 - R5 est l'utilisation (par exemple le démarreur). La diode D4 est passante lors de la décharge. Elle doit supporter le courant de court-circuit pendant au moins 10 ms, et dissiper les pertes Joule lors d'une décharge à fort courant. Le courant de court-circuit est estimé à 264 A pour un assemblage 8S1P d'éléments A123 Systems. La coupure lors d'un court-circuit ou en fin de décharge est assurée par le MOSFET M1, qui doit lui aussi supporter le courant de court-circuit pendant 10 ms au moins. V2 est la source de tension qui pilote M1 (issue du circuit de détection). Idéalement, cette source délivre 6 à 10 V pour que M1 soit passant. La diode zener D3 et le condensateur C2 protègent la grille du MOSFET de tensions trop élevées ou haute fréquence.

Lors de l'ouverture de M1, il peut se produire une surtension supérieure au Vds de M1 du fait de l'annulation du courant dans l'inductance L1. D1 est une diode zener qui, avec la résistance R3 et la diode D2, limitent la vitesse de commutation du MOSFET M1.

L'ensemble R1 - C1 (résistance - condensateur) se trouvent aux bornes + et - de la batterie et permettent également de limiter la surtension à l'ouverture de M1.

A titre d'exemple et de manière non limitative, la figure 4 présente de manière non limitative un exemple de circuit compris dans un mode de réalisation de l'invention permettant la limitation du courant de charge, ainsi que la coupure à la charge. V4 - R5 est l'alternateur de l'appareil ou un chargeur. Il fournit 28 V en fonctionnement normal, mais peut débiter une tension supérieure en cas de défaut de son régulateur. Les essais normalisés donnent une tension de 1,5 fois la tension nominale de la batterie, soit 42 V. Dans la pratique, il est possible que cette tension atteigne 80 V. La limitation du courant de charge est assurée par une diode D4 passante dans le sens décharge, et bloquée dans le sens recharge, en parallèle avec une résistance I1 de limitation de courant.

Ainsi, la diode D4 doit supporter le courant de court-circuit. Cela est réalisable pour une batterie modulaire, mais très difficile pour une batterie de forte capacité. En effet, une batterie non modulaire de 17 Ah par exemple peut fournir un courant de court-circuit de plus de 2000 A. Ainsi, la diode devrait pouvoir supporter ce courant. Des diodes pouvant supporter ce courant n'existent pas en tant que « composant électronique » et en pratique, plusieurs composants de plus faible courant peuvent être connectés en parallèle. Mais l'équilibre des courants de diodes en parallèle est quasi impossible à réaliser, du fait que la tension directe diminue fortement avec la température. Ainsi, la diode la plus chaude supporte tout le courant, ce qui augmente encore sa température jusqu'à destruction.

Le MOSFET M1 est configuré au niveau de sa grille pour être toujours passant dans la phase de charge. La diode D4 est bloquée à la recharge, et le courant de charge passe par I1 et M2. I1 est une résistance de puissance de limitation du courant de charge. Dans d'autres modes de réalisation équivalents, I1 peut aussi être une association de résistances et de Polyswitchs, ou un régulateur de courant à semi-conducteurs. Le MOSFET M2 est passant quand sa tension grille-source, Vgs est à 10 V par exemple. D6 est une diode zener de 18 V par exemple, et D5 une diode zener de 10 V. Ainsi, sous une tension de 28 V (tension de l'alternateur), D6 et D5 sont à la limite de la conduction, il n'y a pas de courant dans R6 et Vgs = 10 V et le courant de charge passe par 11 et M2. Les valeurs des tensions des diodes D5 et D6, permettent donc de définir la valeur de la tension grille-source du MOSFET M2. Le condensateur C5 protège la grille du MOSFET M2 de tensions haute fréquence.

La détection d'un défaut du chargeur comporte deux mesures : la mesure de la tension de chaque élément, et la mesure de la tension globale. Si la tension d'un élément dépasse par exemple 4 V ou si la tension globale dépasse par exemple 32 V, alors l'organe de coupure à la charge est actionné. La charge est à nouveau possible quand la tension est redescendue en dessous de 26 V par exemple, grâce à un comparateur à hystérésis.

Dans la variante numérique le microprocesseur sera câblé avec la batterie pour recevoir sur ses entrées à la fois une tension représentative de la tension de chaque élément cellulaire Vcec constituant la batterie et aussi la mesure de tension globale Vglobale de la batterie, disponible sur les conducteurs conduisant aux cosses extérieures de la batterie. Le programme exécutable par le microprocesseur comprendra un module de code surveillant ces deux tensions Vcec et Vglobale pour après comparaison chacune avec un seuil respectif déterminé mémorisé déclencher la coupure en activant l'élément de disjonction (31), lors du dépassement de ce seuil.

Concernant le déclenchement de l'organe de coupure à la charge, en cas de dépassement de tension ou de température d'un élément unitaire, le blocage de M2 se fait grâce à l'optocoupleur U1. En effet, l'optocoupleur U1 comprend une diode LED (Diode électroluminescente) et un transistor. Ainsi, en cas de dépassement de tension ou de température d'un élément unitaire, un courant circule dans la LED et fait conduire le transistor. La tension grille-source, Vgs, du MOSFET M2 est ramenée proche de 0 V (Vcesat pour tension collecteur-émetteur à saturation de U1). M2 coupe alors le courant de charge (D4 et M2 sont bloqués). Le courant dans la LED de U1 est pris au point commun entre M1 et la batterie, donc sur la tension de la batterie du fait de la déconnexion entre le 0V de la batterie et le 0 V de l'alternateur ou chargeur.

Concernant le déclenchement de l'organe de coupure à la charge, en cas de dépassement de tension ou de température d'un élément, le blocage de M2 se fait grâce à l'optocoupleur U1 : un courant dans sa LED fait conduire le transistor, ainsi le Vgs du MOSFET est ramené proche de 0 V (Vce sat de U1). M2 coupe alors le courant de charge (D4 et M2 sont bloqués). Le courant dans la LED de U1 est pris sur la tension de la batterie du fait de la déconnexion entre le 0V de la batterie et le 0 V de l'alternateur.

Les solutions proposées jusqu'à maintenant décrivent des architectures modulaires externes où plusieurs batteries sont couplées à un bus de données externe permettant la remontée des informations à un superviseur.

L'architecture proposée par l'invention est au contraire interne à la batterie, et peut être une architecture modulaire telle que représentée à titre d'exemple et de manière non limitative à la figure 5. Cette figure présente ainsi une vue schématique de la batterie comprenant plusieurs lignes d'accumulateurs, fixés par des PCB pour former un « U ». Plus précisément un bloc batterie selon certains modes de réalisation tel qu'illustré comprend une pluralité de blocs d'éléments cellulaires en série (de préférence 4 par 1 ou 8 par 1), les blocs étant encadrés à leurs deux extrémités longitudinales par des drageoirs supérieurs et inférieurs. Au niveau de leur extrémité supérieure, les blocs d'accumulateurs sont couplés à une carte PCB, nommée « PCB haut », par exemple au niveau d'orifices dans la carte PCB configurés spécifiquement pour accueillir ladite extrémité des blocs. Des rivets permettent de fixer la carte PCB haut aux drageoirs supérieurs. Cet ensemble forme la face supérieure du bloc batterie. Les mêmes couplages et fixations sont réalisés avec un PCB bas sur la face opposée du bloc batterie, dite face inférieure. Sur une troisième face du bloc batterie est fixé un troisième circuit imprimé (PCB milieu), fixé lui aussi aux drageoirs haut et bas, de façon à former un « U » avec les PCB haut et bas.
En outre, bien que non représenté sur les figure 5 à 7, des PCB intercalaires sont disposées verticalement entre les cellules selon une direction perpendiculaire à la direction S et comportent les résistances de réchauffement (réchauffeurs) de l'ensemble semi-modulaire, et ces résistances sont connectées sur commande du circuit de gestion à une alimentation pour provoquer ledit réchauffement.

Dans certains modes de réalisation, une paire de drageoirs supérieur 71 et inférieur 81 délimite un ensemble de logement cylindriques à section carrée ou polygonale ou circulaire définissant selon la même direction S au moins une ligne de logements cylindriques à section carrée ou polygonale de maintien chacun d'une cellule d'accumulateur lithium.

Dans certains modes de réalisation, les cartes PCB maintenus aux drageoirs supérieurs et inférieurs comportent l'électronique et les liaisons électriques entre les composants de l'électronique du système de gestion et les cellules du bloc semi-modulaire.

Les drageoirs comportent au moins deux lignes de logements parallèles à la direction S dans lesquelles au moins deux lignes de cellules sont disposées selon une direction perpendiculaire à S et reliées entre elles par des languettes fines, selon la direction perpendiculaire P à la direction S, chaque languette fine reliant deux languettes larges de cellules appartenant à deux lignes parallèles différentes pour réaliser une connexion parallèle de deux ensembles parallèles de cellule série. Les languettes larges sont de préférence réalisées par de broches élastiques (Pogo pin, ou des ressorts hélicoïdaux coniques par exemple) disposées entre les languettes larges posées sur les cellules et la face conductrice comportant les plages de contact de la carte de circuit imprimé, évitant ainsi l'utilisation de soudure étain.

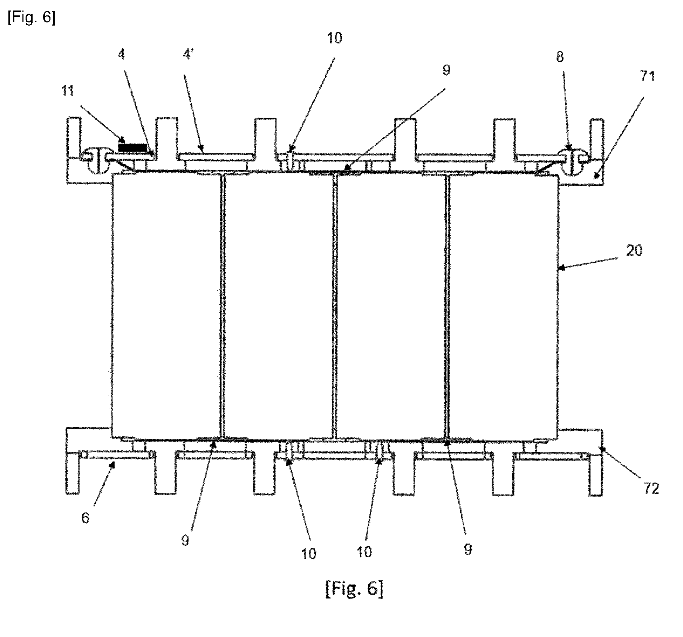

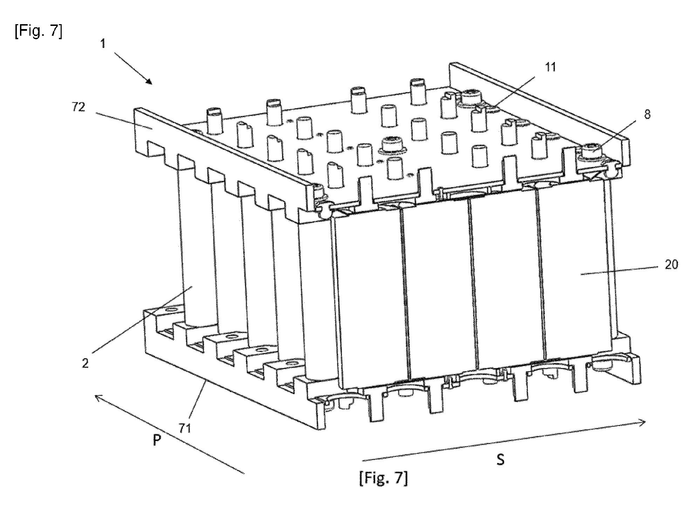

A titre d'exemple et de manière non limitative, la figure 6 présente une vue de face en coupe de la batterie selon l'axe X-X' passant par une ligne d'accumulateurs tandis que la figure 7 présente une vue schématique en coupe longitudinale passant par ledit axe X-X' [passant par une ligne d'accumulateurs ?]. Un organe de coupure (11) est couplé à chaque ligne d'éléments cellulaires en série, comme illustré à la figure 7. Les extrémités des éléments cellulaires (20) sont ainsi insérées dans les logements des drageoirs supérieurs et inférieurs (71, 72). Des languettes fines (9) permettent de relier entre elles deux lignes d'éléments cellulaires (20).

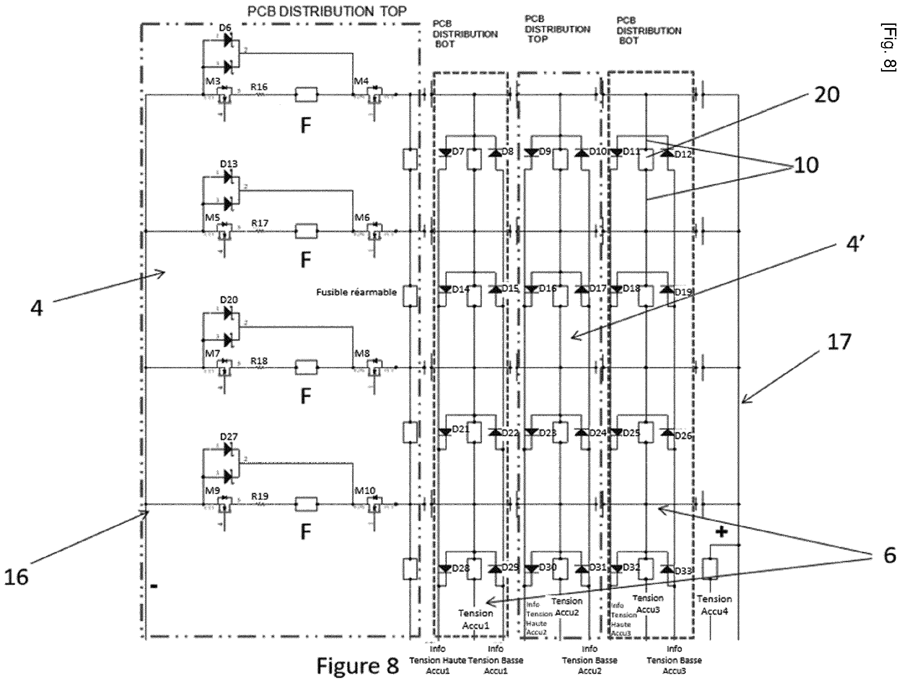

A titre d'exemple et de manière non limitative, la figure 8 présente schématiquement le circuit des cartes PCB haut (4,4') et bas (6) du bloc batterie. La partie PCB 4 est connectée d'une part à chaque cellule parallèle de chaque fin de ligne série (ici quatre lignes séries) et d'autre part par le conducteur de puissance (16) (courant fort) à la cosse de sortie de la batterie. Cette carte 4 comporte les organes de coupure référencé par leur MOSFETs M3 à M10 qui correspondent par paire M3, M4 ; M5, M6 ; M7, M8 ; M9, M10 ; à chacun des organes de coupures 11 schématisés fig.1. Il faut comprendre que chaque élément M3, M4 d'une paire représente, respectivement, de façon simplifiée le schéma électronique de la figure 3 pour chaque référence M3, M5, M7, M9 de la figure 8 et le schéma électronique de la figure 4 pour chaque référence M4, M6, M8, M10 de la figure 8.

En outre, le bloc batterie et le système peuvent comporter différentes caractéristiques permettant d'améliorer leur utilisation et leur fiabilité.

Ainsi, la présente invention peut comporter une carte communication permettant de récupérer les différentes grandeurs des capteurs analogique, de les historiser, de calculer certain paramètre de type état de santé, charge (SOH et SOC). Elle embarque de préférence une liaison CAN (protocole standard dans l'automobile et l'aéronautique), une liaison LIN, et éventuellement un écran LCD pour l'IHM (Interface Homme-Machine).

La batterie intègre une fonction de mise hors/sous tension. Cette fonction permet de stocker la batterie, de faire des opérations de maintenance avec une sécurité accrue. L'utilisateur peut également mettre hors tension la batterie lorsqu'il ne l'utilise pas pour éviter toutes décharge intempestive de la batterie et tout risque de feu lié à un instrument qui dysfonctionne.

Les réchauffeurs sont de préférence fabriqués en enroulant du cuivre sur une couche interne d'un PCB. Cela permet un moyen de production simple et peu couteux. Cette technique permet d'intégrer des connecteurs.

De préférence, le bloc ne comprend pas de soudure à l'étain lors de l'assemblage. Cela permet de proposer un système ne comprenant pas tous les fils de certains dispositifs de l'art antérieur. Des connecteurs sont ainsi placés sur les réchauffeurs, sur les drageoirs et sur les PCB distribution haut et bas.

Le BMS vient ensuite se connecter sur tous ces connecteurs, par une fixation mécanique pour ne pas risquer de débrancher un connecteur lors de vibrations à l'utilisation.

Contrairement à certaines batteries de l'art antérieur, le système de la présente invention n'a qu'un mode de fonctionnement actif pour toutes les fonctionnalités de sécurité assurées par le BMS, et n'a pas de mode de veille. Ceci est rendu possible par l'utilisation de composants à très basse consommation. En effet, grâce au faible courant de veille de par exemple 80 µAmpère environ, les fonctionnalités de sécurité du BMS de la batterie peuvent rester en permanence sous tension sans que soit pénalisée la durée maximale de stockage.

Le bloc batterie de la présente invention présente une très bonne tenue aux chocs et vibrations. En effet, il est séparé mécaniquement en deux parties : une partie externe solidaire du boitier, une partie interne incluant les cellules d'accumulateurs. Les deux parties sont de préférence découplées mécaniquement par un matériau souple qui améliore la tenue aux chocs et vibrations de la batterie. La face avant, les interfaces utilisateurs et la carte électronique du BMS sont solidaires du boitier. Les cellules d'accumulateur, les intercalaires, les réchauffeurs, le relais électromécanique et la « carte de distribution » forment la partie interne découplée mécaniquement. Toutes les connexions électriques entre la partie interne et la partie externe présentent une certaine souplesse dans les trois directions de l'espace (axes x,y,z).

Une bonne isolation thermique permet une meilleure efficacité du réchauffeur électrique : consommation électrique plus basse pour amener les éléments à leur température idéale de fonctionnement. L'isolation thermique permet également de diminuer les écarts de température subis par les cellules d'accumulateur dans le cas d'un aéronef qui alternerait des périodes au sol à température élevé (par exemple : +30°C) et des périodes en vol à température très basse (par exemple : -10°C). Cela peut être le cas pour des appareils pour le largage de parachutistes. La batterie de la présente invention peut par exemple utiliser du liège ignifugé de qualité aéronautique. L'avantage de ce matériau est qu'il assure à la fois la fonction d'isolation thermique, de protection thermique et de découplage mécanique. La protection thermique et l'isolation thermique font également office d'isolement électrique entre les parties sous tensions interne à la batterie et le boitier métallique. Du fait qu'il y a deux matériaux isolants, la batterie de la présente invention présente intrinsèquement une double isolation électrique entre les parties sous-tension et le boitier. Cette disposition minimise le risque de court-circuit interne en cas de choc violant (amplitude de choc supérieur aux essais normalisés). Ce matériau résiste très bien à l'usure provoqué par des vibrations (fretting corrosion).

Il paraît à la lecture des caractéristiques ci-dessus décrite que le système proposé par la présente invention comporte les avantages suivants :
Un seul dispositif assure en même temps la protection court-circuit, surintensité et décharge profonde.
Détection d'une surintensité et coupure sans recourir à une mesure de courant.
Courant de disjonction automatiquement adapté aux caractéristiques des éléments d'accumulateur.
Pas de shunt, pas de capteur magnétique, pas d'élément chauffant.
Courbe de disjonction semblable à une courbe magnétothermique.
La courbe de disjonction suit le vieillissement des éléments d'accumulateur
Limitation du courant de charge robuste, sans recourir à une mesure de courant.
Composants de puissance ordinaires (composants CMS) du fait de la modularité et de courants raisonnables.
Equilibre des courants dans les composants de puissance.
Monitoring des différentes grandeurs par microcontrôleur.
Communication sur un bus de donnée standard, afficheur LCD.
Pas de réglage fin nécessaire.
Très basse consommation statique.
Circuits toujours actifs, pas de mode « actif » et « veille ».
Très haut niveau de sureté de fonctionnement (haut MTBF).
Utilisation de composants standards, non stratégiques et non spécifiques à un usage pour BMS.

On comprendra aisément à la lecture de la présente demande que les particularités de la présente invention, comme généralement décrits et illustrés dans les figures, puissent être arrangés et conçus selon une grande variété de configurations différentes. Ainsi, la description de la présente invention et les figures afférentes ne sont pas prévues pour limiter la portée de l'invention mais représentent simplement des modes de réalisation choisis.

L'homme de métier comprendra que les caractéristiques techniques d'un mode de réalisation donné peuvent en fait être combinées avec des caractéristiques d'un autre mode de réalisation à moins que l'inverse ne soit explicitement mentionné ou qu'il ne soit évident que ces caractéristiques sont incompatibles. De plus, les caractéristiques techniques décrites dans un mode de réalisation donné peuvent être isolées des autres caractéristiques de ce mode à moins que l'inverse ne soit explicitement mentionné.

Il doit être évident pour les personnes versées dans l'art que la présente invention permet des modes de réalisation sous de nombreuses autres formes spécifiques sans l'éloigner du domaine défini par la portée des revendications jointes, ils doivent être considérés à titre d'illustration et l'invention ne doit pas être limitée aux détails donnés ci-dessus.

### LISTE DES SIGNES DE REFERENCE

1. Bloc batterie
2. Bloc d'éléments cellulaires en série
20. Eléments cellulaires
3. Système BMS
4, 4'. PCB haut (distribution)
5. PCB milieu (BMS)
6. PCB bas (distribution)
71. Drageoir inférieur
72. Drageoir supérieur
8. Rivets
9. Languette (fine)
10. Pogo pin
11. Organe de coupure
12. Réchauffeur
13. Thermostat/sonde T°C
14. Equilibreur
15. Sur/sous tension
16. Conducteur de puissance (courant fort) à la cosse positive
17. Conducteur de puissance (courant fort) à la cosse négative
31. Liaison circuit entre le BMS et les organes de coupures
F. Fusibles

## Revendications

1. Système de gestion de batteries (BMS, 3) d'accumulateurs d'un élément semi modulaire comprenant une pluralité d'éléments cellulaires (20) au lithium connectés en série pour former une ligne, ledit système de gestion de batteries d'accumulateurs comprenant au moins deux lignes séries reliées en parallèle constituant l'élément semi modulaire, et au moins un circuit de détection, ledit circuit de détection comporte au moins un dispositif de détection de décharge ou de court-circuit et au moins un dispositif de surveillance de tension et de température d'au moins un des éléments cellulaires, ledit système de gestion de batteries d'accumulateurs comprenant un dispositif de disjonction, le circuit de détection commandant ledit dispositif de disjonction comprenant au moins un organe de coupure (11) par ligne, de préférence seulement un par ligne, et relié d'une part au pôle négatif ou positif de chaque ensemble d'éléments cellulaires (20) ou chaque batterie et d'autre part à la cosse négative respectivement positive de la batterie, l'organe de coupure (11) comprenant pour chaque ligne un organe de coupure à la charge, un organe de coupure à la décharge, et des composants électroniques limitant le courant à la charge, de préférence uniquement à la charge, et ledit organe de coupure à la charge comprenant au moins deux, de préférence seulement deux, MOSFET (M1, M2) par ligne ; un premier MOSFET (M1) effectuant une coupure du circuit en cas de décharge en dessous d'un seuil ou lors d'un court-circuit, un deuxième MOSFET (M2) effectuant une coupure à la charge en cas de dépassement, de tension ou de température, d'un élément, dudit circuit, les composants électroniques tels qu'un ensemble de diode, résistances, condensateur, par exemple autour du deuxième MOSFET (M2), effectuant une limitation de courant à la charge.

2. Système de gestion de batteries (BMS, 3) d'accumulateurs d'un élément semi modulaire selon la revendication 1, **caractérisé en ce que** le premier MOSFET (M1) est connecté par sa source à la borne négative d'un jeu de cellules, ce premier MOSFET (M1) reçoit sur sa grille une source de tension (V2) qui pilote (M1) cette source délivrant une tension choisie (par exemple 6 à 10 V ) pour que le premier MOSFET (M1) soit passant, une diode Zener (D3) est branchée en opposition entre la grille et la source du premier MOSFET (M1) et un condensateur (C2) protègent la grille du premier MOSFET (M1) de tensions trop élevées ou haute fréquence et une diode zener (D1) montée en opposition entre la grille du premier MOSFET (M1) et le drain et en série avec une résistance (R3) et une diode (D2) en sens passant dans le sens drain grille, (D1, D2, R3) limitant la vitesse de commutation du premier MOSFET (M1) et un circuit constitué d'une diode Schottky (D4) limite le courant de charge, cette diode Schottky (D4) est montée en opposition sur le drain du premier MOSFET (M1) dans le sens de charge et en série avec un condensateur C1 et une résistance R1 reliés à la borne positive de la batterie pour permettre également de limiter la surtension à l'ouverture du premier MOSFET M1, en parallèle sur la diode Schottky (D4) est monté une résistance I1 reliée d'une part à la cathode de la diode et d'autre part au drain du deuxième MOSFET (M2) dont la source est relié à l'anode de la diode Schottky (D4), la grille du deuxième MOSFET (M2) étant commandée par une sortie du circuit de détection pour empêcher la charge.

3. Système de gestion de batteries (BMS, 3) d'accumulateurs d'un élément semi modulaire selon la revendication 1, **caractérisé en ce que** le deuxième MOSFET (M2) est branché par sa grille à la base du phototransistor d'un optocoupleur dont l'émetteur est relié à la source de M2, entre ces deux points sont branchés une diode zener (D5) et un condensateur (C5), par la carte BMS, la diode électroluminescente de l'opto-coupleur est branchée par sa cathode à la borne négative de la batterie ou de l'ensemble modulaire de cellules et reçoit sur son anode la commande envoyant un courant dans la LED en cas de dépassement de tension ou de température d'un élément relevé.

4. Système de gestion de batteries (BMS, 3) d'accumulateurs d'un élément semi modulaire selon la revendication 1, **caractérisé en ce que** l'agencement du circuit de disjonction associé aux deux MOSFETs est interposé entre le pôle de sortie d'une ligne et la même borne, de même polarité (positive ou négative) de la batterie.

5. Système de gestion de batteries (BMS, 3) d'accumulateurs d'un élément semi modulaire selon la revendication 1, **caractérisé en ce que** le BMS est connecté et contrôle chaque élément cellulaire (20) et chaque ligne d'accumulateur du circuit et surveille la tension de chaque cellule et de chaque ligne série de cellules.

6. Système de gestion de batteries (BMS, 3) d'accumulateurs d'un élément semi modulaire selon l'une des revendications précédentes dans lequel le circuit de détection comporte une ou plusieurs des fonctionnalités suivantes :
Equilibrage de la tension des cellules;
Détection tension trop basse et ouverture du circuit
Détection, par un circuit de mesure de tension, de court-circuit, de décharge profonde et de surintensité pour déclencher la disjonction d'un groupe de cellules par ouverture du circuit
Détection tension trop haute d'une des cellules de la batterie et ouverture du circuit.

7. Système de gestion de batteries (BMS, 3) d'accumulateurs d'un élément semi modulaire selon la revendication 4 **caractérisé en ce que** l'équilibrage de tension est réalisé par une fonction OU à diode reliant chacune des cellules montées en parallèle avec la polarité négative du pont diviseur du circuit de mesure de tension de court-circuit, décharge profonde et de surintensité.

8. Système de gestion de batteries (BMS, 3) d'accumulateurs d'un élément semi modulaire selon la revendication 4, **caractérisé en ce que** chaque élément cellulaire d'une ligne est relié à chaque élément cellulaire adjacent d'une autre ligne par un élément constituant un fusible thermique (F), de préférence réarmable.

9. Système de gestion de batteries (BMS, 3) d'accumulateurs d'un élément semi modulaire selon la revendication 1 ou 4 **caractérisé en ce que** le circuit de détection comporte les fonctionnalités suivantes : intègre une surveillance de la température qui reste constamment active, même si la batterie est sur « off, en analysant la température dans l'enveloppe de la batterie, mesurée par une sonde (13) montée sur la partie centrale des cartes de chaque module.

10. Système de gestion de batteries (BMS, 3) d'accumulateurs d'un élément semi modulaire selon la revendication 1 **caractérisé en ce que** les composants électroniques du dispositif de disjonction limitant le courant à la charge, de préférence uniquement à la charge, pour la régulation du courant de charge comprennent un composant tel qu'une résistance, qui est passant dans un sens, et résistif, tel une diode montée en opposition, dans l'autre sens.

11. Système de gestion de batteries (BMS, 3) d'accumulateurs d'un élément semi modulaire selon la revendication 1, dans lequel le circuit est agencé de façon à ce que les organes de coupure à la charge et à la décharge sont pilotés indépendamment.

12. Bloc batterie (1) à courant fort, semi-modulaire, série et parallèle constitué de cellules d'accumulateurs lithium de mêmes caractéristiques reliées en série pour former une ligne par des connexions selon une direction donnée S correspondant au sens des courants forts pour obtenir la tension nécessaire, et destiné à pouvoir être associé en parallèle avec une autre ligne de cellules d'accumulateurs, ledit bloc comprenant un système de gestion (3) selon une des revendications précédentes, et **caractérisé en ce que** :
une paire de drageoirs supérieur (71) et inférieur (72) qui délimitent un ensemble de logement cylindriques à section carrée ou polygonale ou circulaire définissant selon la même direction S au moins une ligne de logements cylindriques à section carrée ou polygonale de maintien chacun d'une cellule d'accumulateur lithium ;
les connexions entre les cellules d'accumulateurs d'une même ligne selon la direction S sont assurées par des languettes larges (9) reliant sur chaque face supérieure ou inférieure du module chaque paire de cellules adjacentes montées en série par leur pôles de polarité opposées selon la première direction S, les languettes de connexion (9) d'une face étant décalées d'une cellule sur l'autre face ;
les drageoirs (71, 72) comportent au moins deux lignes de logements parallèles à la direction S dans lesquelles au moins deux lignes de cellules sont disposées selon une direction perpendiculaire à S et reliées entre elles soit par des languettes fines jouant le rôle de fusible soit par des fusibles réarmables (F, fig.2), selon la direction perpendiculaire P à la direction S, chaque fusible (F) reliant deux cellules appartenant à deux lignes parallèles différentes pour réaliser une connexion parallèle entre chaque cellule de deux ensembles parallèles de cellule série.

13. Bloc batterie (1) à courant fort selon la revendication 12, **caractérisé en ce que** les drageoirs maintiennent par les côtés à la partie supérieure (71) et inférieure (72) des cartes PCB (printed circuit board) en circuit imprimé comportant l'électronique et les liaisons électrique entre les composants de l'électronique du système de gestion et les cellules du bloc semi-modulaire ;
des PCB intercalaires (12,13, fig 1) sont disposées verticalement entre les cellules selon une direction perpendiculaire à la direction S comportent au moins les résistances de réchauffement de l'ensemble semi-modulaire et ces résistances sont connectées sur commande du circuit de gestion à une alimentation ;
la partie PCB (6) disposée sous les cellules contribue à la récupération des potentiels de chacune des cellules du bloc semi-modulaire pour les fournir au circuit de gestion des tensions et de l'équilibrage du système de gestion du bloc semi-modulaire.

14. Bloc batterie (1) à courant fort selon la revendication 12 ou 13 **caractérisée en ce que** des résistances sont montés entre deux plages de contact (non représentées) sur les cartes PCB supérieure (4, 4') et/ou inférieure (6) et le contact avec les cellules et les pistes du circuit imprimé supérieur ou inférieur sont réalisés par des broches élastiques, ou des ressorts hélicoïdaux coniques, par exemple, disposées entre les cellules et la face conductrice comportant les plages de contact de la carte de circuit imprimé, évitant ainsi l'utilisation de soudure étain.

15. Bloc batterie (1) à courant fort, semi-modulaire selon l'une des revendications 12 à 14, **caractérisé en ce que** la carte centrale verticale (13) comporte des sondes de températures et un thermostat.

16. Bloc batterie (1) à courant fort, semi-modulaire selon l'une des revendications 12 à 15, **caractérisé en ce que** la carte (5) comprenant le système de gestion (BMS, 3) est disposée verticalement sur le côté du bloc batterie (1) de façon à former un U avec les autres PCB (4, 6) dudit bloc.

## Patentansprüche

1. Batterienverwaltungssystem (BMS, 3) von Akkumulatoren eines halbmodularen Elements, das eine Vielzahl von Lithiumzellenelementen (20) umfasst, die in Reihe geschaltet sind, um eine Linie zu bilden, wobei das Batterieverwaltungssystem von Akkumulatoren mindestens zwei serielle Linien umfasst, die parallel geschaltet sind, die ein halbmodulares Element bilden, und mindestens eine Erfassungsschaltung, wobei die Erfassungsschaltung mindestens eine Entladungserfassungsvorrichtung oder Kurzschlusserfassungsvorrichtung und mindestens eine Spannungs- und Temperaturüberwachungsvorrichtung mindestens eines der Zellenelemente umfasst, wobei das Batterieverwaltungssystem von Akkumulatoren eine Abschaltvorrichtung umfasst, die Erfassungsschaltung die Abschaltvorrichtung steuert, die mindestens ein Abschaltorgan (11) pro Linie umfasst, bevorzugt nur eines pro Linie, und verbunden mit einerseits dem negativen oder positiven Pol jeder Zellenelementanordnung (20) oder jeder Batterie und andererseits mit der negativen bzw. positiven Anschlusshülse der Batterie, wobei das Abschaltorgan (11) für jede Linie ein Abschaltorgan beim Laden, ein Abschaltorgan beim Entladen und elektronische Komponenten umfasst, die den Strom beim Laden einschränken, bevorzugt nur beim Laden, und wobei das Abschaltorgan beim Laden mindestens zwei, bevorzugt nur zwei, MOSFETs (M1, M2) pro Linie umfasst; wobei ein erster MOSFET (M1) eine Abschaltung der Schaltung im Falle von Entladung unter einem Schwellenwert oder bei einem Kurzschluss durchführt, ein zweiter MOSFET (M2) eine Abschaltung beim Laden im Falle von Überschreitung von Spannung oder Temperatur eines Elements der Schaltung durchführt, wobei die elektronischen Komponenten, wie eine Baugruppe aus Diode, Widerständen, Kondensator, beispielsweise um den zweiten MOSFET (M2), eine Stromeinschränkung beim Laden durchführt.

2. Batterienverwaltungssystem (BMS, 3) von Akkumulatoren eines halbmodularen Elements nach Anspruch 1, **dadurch gekennzeichnet, dass** der erste MOSFET (M1) durch seine Quelle mit der negativen Klemme eines Zellensatzes verbunden ist, wobei dieser erste MOSFET (M1) auf seinem Gitter eine Spannungsquelle (V2) empfängt, die (M1) steuert, wobei diese Quelle eine ausgewählte Spannung (beispielsweise 6 bis 10 Volt) abgibt, damit der erste MOSFET (M1) durchlässig ist, eine Zenerdiode (D3) gegenläufig zwischen dem Gitter und der Quelle des ersten MOSFET (M1) angeschlossen ist, und einen Kondensator (C2), der das Gitter des ersten MOSFET (M1) vor zu hohen Spannungen oder zu hoher Frequenz schützt, und eine Zenerdiode (D1), die gegenläufig zwischen dem Gitter des ersten MOSFET (M1) und dem Drain und in Serie zwischen einem Widerstand (R3) und einer Diode (D2) in der Durchlassrichtung in der Drain-Gitter-Richtung montiert ist, wobei (D1, D2, R3) die Umschaltgeschwindigkeit des ersten MOSFET (M1) einschränken, und eine Schaltung, die aus einer Schottky-Diode (D4) besteht, den Ladestrom einschränkt, wobei diese Schottky-Diode (D4) gegenläufig auf dem Drain des ersten MOSFET (M1) in einer Laderichtung montiert ist und in Serie mit einem Kondensator C1 und einem Widerstand R1, die mit der positiven Klemme der Batterie verbunden sind, um auch zu erlauben, die Überspannung beim Öffnen des ersten MOSFET M1 einzuschränken, parallel auf der Schottky-Diode (D4) ein Widerstand I1 montiert ist, der einerseits mit der Kathode der Diode und andererseits mit dem Drain des zweiten MOSFET (M2) verbunden ist, dessen Quelle mit der Anode der Schottky-Diode (D4) verbunden ist, wobei das Gitter des zweiten MOSFET (M2) durch einen Ausgang der Erfassungsschaltung gesteuert ist, um das Laden zu verhindern.

3. Batterienverwaltungssystem (BMS, 3) von Akkumulatoren eines halbmodularen Elements nach Anspruch 1, **dadurch gekennzeichnet, dass** der zweite MOSFET (M2) über sein Gitter an die Basis des Fototransistors eines Optokoppler angeschlossen ist, dessen Sender mit der Quelle von M2 verbunden ist, zwischen diesen beiden Punkten eine Zenerdiode (D5) und ein Kondensator (C5) über die BMS-Karte angeschlossen sind, die Licht emittierende Diode des Optokoppler über ihre Kathode an die negative Klemme der Batterie oder der modularen Baugruppe von Zellen angeschlossen ist und an ihrer Anode den Befehl empfängt, der bei Überschreiten der Spannung oder Temperatur eines erhobenen Elements einen Strom in die LED sendet.

4. Batterienverwaltungssystem (BMS, 3) von Akkumulatoren eines halbmodularen Elements nach Anspruch 1, **dadurch gekennzeichnet, dass** die Einrichtung der Abschaltschaltung, die den beiden MOSFETs zugeordnet ist, zwischen dem Ausgangspol einer Linie und derselben Klemme mit gleicher Polarität (positiv oder negativ) der Batterie eingefügt ist.

5. Batterienverwaltungssystem (BMS, 3) von Akkumulatoren eines halbmodularen Elements nach Anspruch 1, **dadurch gekennzeichnet, dass** das BMS mit jedem Zellenelement (20) und jeder Akkumulatorlinie der Schaltung verbunden ist und diese steuert und die Spannung jeder Zelle und jeder seriellen Linie von Zellen überwacht.

6. Batterienverwaltungssystem (BMS, 3) von Akkumulatoren eines halbmodularen Elements nach einem der vorstehenden Ansprüche, wobei die Erfassungsschaltung eine oder mehreren der folgenden Funktionen umfasst:
Ausgleichen der Spannung der Zellen;
Erfassung zu niedriger Spannung und Öffnen der Schaltung
Erfassung über eine Spannungsmessschaltung von Kurzschluss, Tiefentladung und Überstrom, um die Abschaltung einer Gruppe von Zellen durch Öffnen der Schaltung auszulösen
Erfassung zu hoher Spannung einer der Zellen der Batterie und Öffnen der Schaltung.

7. Batterienverwaltungssystem (BMS, 3) von Akkumulatoren eines halbmodularen Elements nach Anspruch 4, **dadurch gekennzeichnet, dass** der Spannungsausgleich durch eine ODER-Funktion mit Diode realisiert wird, die jede der parallel geschalteten Zellen mit der negativen Polarität der Teilerbrücke der Spannungs-, Kurzschluss-, Tiefentladungs- und Überstrommessschaltung verbindet.

8. Batterienverwaltungssystem (BMS, 3) von Akkumulatoren eines halbmodularen Elements nach Anspruch 4, **dadurch gekennzeichnet, dass** jedes Zellenelement einer Linie mit jedem angrenzenden Zellenelement einer anderen Linie durch ein Element verbunden ist, das eine Thermosicherung (F), die bevorzugt rückstellbar ist, bildet.

9. Batterienverwaltungssystem (BMS, 3) von Akkumulatoren eines halbmodularen Elements nach Anspruch 1 oder 4, **dadurch gekennzeichnet, dass** die Erfassungsschaltung die folgenden Funktionen umfasst: Integrieren einer Temperaturüberwachung, die ständig aktiv bleibt, selbst wenn die Batterie auf "aus" steht, indem die Temperatur in dem Mantel der Batterie analysiert wird, die durch eine Sonde (13) gemessen wird, die auf dem zentralen Teil der Karten jedes Moduls montiert ist.

10. Batterienverwaltungssystem (BMS, 3) von Akkumulatoren eines halbmodularen Elements nach Anspruch 1, **dadurch gekennzeichnet, dass** die elektronischen Komponenten der Abschaltvorrichtung, die den Strom beim Laden, bevorzugt nur beim Laden, nur zur Regulierung des Ladestroms einschränken, eine Komponente, wie einen Widerstand, umfassen, der in eine Richtung durchlässig ist, und in der anderen Richtung resistiv, wie eine gegenläufig geschaltete Diode.

11. Batterienverwaltungssystem (BMS, 3) von Akkumulatoren eines halbmodularen Elements nach Anspruch 1, wobei die Schaltung derart eingerichtet ist, dass die Abschaltorgane bei jedem Laden und jedem Entladen unabhängig gesteuert sind.

12. Halbmodularer serieller und paralleler Starkstrom-Batterieblock (1), der aus Lithiumakkumulatorzellen mit denselben Merkmalen besteht, die in Serie geschaltet sind, um eine Linie durch Verbindungen gemäß einer gegebenen Richtung S zu bilden, die der Richtung der Starkströme entspricht, um die erforderliche Spannung zu erhalten, und der dazu bestimmt ist, parallel einer anderen Linie von Akkumulatorzellen zugeordnet zu werden, wobei der Block ein Verwaltungssystem (3) nach einem der vorstehenden Ansprüche umfasst, und **dadurch gekennzeichnet, dass**:
ein Paar aus oberer (71) und unterer Aufnahme (72), das eine Anordnung zylindrischer Aufnahmen mit quadratischem oder vieleckigem oder kreisförmigem Querschnitt abgrenzt, die gemäß derselben Richtung S mindestens eine Linie zylindrischer Aufnahmen mit quadratischem oder vieleckigem Querschnitt definieren, zum Halten jeder einer Lithiumakkumulatorzelle definieren;
die Verbindungen zwischen den Akkumulatorzellen derselben Linie entlang der Richtung S durch breite Laschen (9) sichergestellt sind, die auf jeder oberen oder unteren Fläche des Moduls jedes Paares angrenzender Zellen, die in Serie montiert sind, über ihre Pole mit entgegengesetzter Polarität gemäß der ersten Richtung S verbinden, wobei die Verbindungslaschen (9) einer Fläche von einer Zelle zu der anderen Fläche versetzt sind;
die Aufnahmen (71, 72) mindestens zwei Linien von Aufnahmen parallel zu der Richtung S umfassen, in welchen mindestens zwei Linien von Zellen gemäß einer Richtung senkrecht zu S angeordnet und miteinander entweder durch feinere Laschen, die die Aufgabe einer Sicherung spielen, oder durch rückstellbare Sicherungen (F, Fig. 2) gemäß der Richtung P senkrecht zu der Richtung S verbunden sind, wobei jede Sicherung (F) zwei Zellen verbindet, die zu zwei unterschiedlichen parallelen Linien gehören, um eine parallele Verbindung zwischen jeder Zelle von zwei parallelen Baugruppen der seriellen Zelle herzustellen.

13. Starkstrom-Batterieblock (1) nach Anspruch 12, **dadurch gekennzeichnet, dass** die Aufnahmen über die Seiten an dem oberen Teil (71) und unteren Teil (72) PCB-Karten (gedruckte Leiterplatten) in gedruckter Schaltung halten, die die Elektronik umfassen, und elektrische Verbindungen zwischen den Komponenten der Elektronik des Verwaltungssystems und den Zellen des halbmodularen Blocks;
Zwischenlagen-PCBs (12, 13, Fig. 1) vertikal zwischen den Zellen gemäß einer Richtung senkrecht zu der Richtung S angeordnet sind, die mindestens die Aufwärmwiderstände der halbmodularen Baugruppe umfassen, und diese Widerstände auf Befehl der Verwaltungsschaltung mit einer Stromversorgung verbunden werden;
der PCB-Teil (6), der unter den Zellen angeordnet ist, zur Rückgewinnung von Spannungen jeder der Zellen des halbmodularen Blocks beiträgt, um sie an die Schaltung zur Verwaltung der Spannungen und Ausgleichen des Verwaltungssystems des halbmodularen Blocks zu liefern.

14. Starkstrom-Batterieblock (1) nach Anspruch 12 oder 13, **dadurch gekennzeichnet, dass** die Widerstände zwischen zwei Kontaktbereichen (nicht dargestellt) auf der oberen PCB-Karte (4, 4') und/oder unteren PCB-Karte (6) montiert sind, und der Kontakt mit den Zellen und den Bahnen der oberen oder unteren gedruckten Schaltung durch elastische Kontaktstifte oder konische Spiralfedern hergestellt ist, die beispielsweise zwischen den Zellen angeordnet sind, und die leitfähige Fläche Kontaktbereiche der gedruckten Schaltung umfasst, wodurch die Verwendung von Lötzinn vermieden wird.

15. Halbmodularer Starkstrom-Batterieblock (1) nach einem der Ansprüche 12 bis 14, **dadurch gekennzeichnet, dass** die zentrale vertikale Karte (13) Temperatursonden und einen Thermostat umfasst.

16. Halbmodularer Starkstrom-Batterieblock (1) nach einem der Ansprüche 12 bis 15, **dadurch gekennzeichnet, dass** die Karte (5), die das Verwaltungssystem (BMS, 3) umfasst, vertikal an der Seite des Batterieblocks (1) derart angeordnet ist, dass sie mit den anderen PCBs (4, 6) des Blocks ein U bildet.

## Claims

1. Battery management system (BMS, 3) for accumulators of a semi-modular element comprising a plurality of lithium cell elements (20) connected in series to form a line, said battery management system for accumulators comprising at least two serial lines connected in parallel constituting the semi-modular element, and at least one detection circuit, said detection circuit comprising at least one discharge or short-circuit detection device and at least one device for monitoring the voltage and temperature of at least one of cells elements, said battery management system (BMS, 3) for accumulators comprising a circuit breaker device, said detection circuit controlling said circuit breaker device comprising at least one switching device (11) per line, preferably only one per line, and connected on the one hand to the negative or positive pole of each set of cell elements (20) or each battery and on the other hand to the positive or negative terminal, respectively, of the battery, the switching device (11) comprising, for each line, a load breaking device, a discharge breaking device, and electronic components limiting the current at the load, preferably only at the load, and said load breaking device comprising at least two, preferably only two, MOSFETs (M1, M2) per line; a first MOSFET (M1) performing a circuit break in the event of discharge below a threshold or during a short circuit, a second MOSFET (M2) performing a load break in the event of voltage or temperature overshoot of an element of said circuit, the electronic components such as a set of diodes, resistors, capacitors, for example around the second MOSFET (M2), performing a current limitation at the load.

2. Battery management system (BMS, 3) for accumulators of a semi-modular element according to claim 1, **characterized in that** the first MOSFET (M1) is connected by its source to the negative terminal of a set of cells, this first MOSFET (M1) receives, on its gate, a voltage source (V2) that drives (M1), this source delivering a chosen voltage (for example 6 to 10 V) so that the first MOSFET (M1) is on, a Zener diode (D3) is connected in opposition between the gate and the source of the first MOSFET (M1) and a capacitor (C2) protect the gate of the first MOSFET (M1) from excessively high or high-frequency voltages, and a Zener diode (D1) mounted in opposition between the gate of the first MOSFET (M1) and the drain and in series with a resistor (R3) and a diode (D2) in the forward direction in the drain-to-gate direction, (D1, D2, R3) limiting the switching speed of the first MOSFET (M1) and a circuit consisting of a Schottky diode (D4) limits the load current, this Schottky diode (D4) is mounted in opposition on the drain of the first MOSFET (M1) in the charging direction, and in series with a capacitor C1 and a resistor R1 connected to the positive terminal of the battery to also limit the overvoltage when opening the first MOSFET M1, in parallel on the Schottky diode (D4) a fixed resistor I1 is mounted that is connected on the one hand to the cathode of the diode and on the other hand to the drain of the second MOSFET (M2) whose source is connected to the anode of the Schottky diode (D4), the gate of the second MOSFET (M2) being controlled by an output of the detection circuit to prevent the load.

3. Battery management system (BMS, 3) for accumulators of a semi-modular element according to claim 1, **characterized in that** the second MOSFET (M2) is connected by its gate to the base of the phototransistor of an optocoupler whose emitter is connected to the source of M2; between these two points, a Zener diode (D5) and a capacitor (C5) are connected by the BMS card; the light-emitting diode of the optocoupler is connected by its cathode to the negative terminal of the battery or of the modular set of cells and receives, on its anode, the command sending a current into the LED in case of detected voltage or temperature overshoot of an element.

4. Battery management system (BMS, 3) for accumulators of a semi-modular element according to claim 1, **characterized in that** the arrangement of the disconnection circuit associated with the two MOSFETs is interposed between the output pole of a line and the same terminal, of the same polarity (positive or negative), of the battery.

5. Battery management system (BMS, 3) for accumulators of a semi-modular element according to claim 1, **characterized in that** the BMS is connected to and controls each cell element (20) and each accumulator line of the circuit and monitors the voltage of each cell and each serial line of cells.

6. Battery management system (BMS, 3) for accumulators of a semi-modular element according to one of the preceding claims, wherein the detection circuit comprises one or more of the following functionalities:
Cell voltage balancing;
Detection of excessively low voltage and open circuit
Detection, by a voltage measurement circuit, of short-circuit, deep discharge and overcurrent to trigger the disconnection of a group of cells by opening the circuit
Detection of excessively high voltage of one of the battery cells and opening of the circuit.

7. Battery management system (BMS, 3) for accumulators of a semi-modular element according to claim 4, **characterized in that** the voltage balancing is performed by a diode OR function connecting each of the cells connected in parallel with the negative polarity of the divider bridge of the short-circuit, deep discharge and overcurrent voltage measurement circuit.

8. Battery management system (BMS, 3) for accumulators of a semi-modular element according to claim 4, **characterized in that** each cell element of a line is connected to each adjacent cell element of another line by an element constituting a thermal fuse (F), preferably resettable.

9. Battery management system (BMS, 3) for accumulators of a semi-modular element according to claim 1 or 4, **characterized in that** the detection circuit comprises the following functionalities: integrates temperature monitoring that remains constantly active, even if the battery is "off, by analyzing the temperature in the battery envelope, measured by a probe (13) mounted on the central part of the cards of each module.

10. Battery management system (BMS, 3) for accumulators of a semi-modular element according to claim 1, **characterized in that** the electronic components of the circuit breaker device limiting the current to the load, preferably only to the load, for regulating the load current comprise a component such as a resistor, which is conductive in one direction, and resistive, like a diode connected in opposition, in the other direction.

11. Battery management system (BMS, 3) for accumulators of a semi-modular element according to claim 1, **characterized in that** the circuit is arranged in such a way that the charging and discharging switching devices are controlled independently.

12. High-current, semi-modular, series and parallel battery pack (1) consisting of lithium accumulator cells of the same characteristics connected in series to form a line by connections in a given direction S corresponding to the direction of the high currents to obtain the necessary voltage, and intended to be able to be associated in parallel with another line of accumulator cells, said pack comprising a management system (3) according to one of the preceding claims, and **characterized in that**:
a pair of upper (71) and lower (72) bezels that delimit a set of cylindrical housings with a square or polygonal or circular section defining, in the same direction S, at least one line of cylindrical housings with a square or polygonal section each holding a lithium accumulator cell;
the connections between the accumulator cells of the same line in the direction S are ensured by wide tongues (9) connecting, on each upper or lower face of the module, each pair of adjacent cells connected in series by their poles of opposite polarity in the first direction S, the connecting tongues (9) on one face being offset by one cell on the other face;
the bezels (71, 72) comprise at least two lines of housings parallel to the direction S in which at least two lines of cells are arranged in a direction perpendicular to S and interconnected either by thin tongues acting as a fuse or by resettable fuses (F, Fig. 2), in the direction P perpendicular to the direction S, each fuse (F) connecting two cells belonging to two different parallel lines to make a parallel connection between each cell of two parallel sets of serial cells.

13. High-current battery pack (1) according to claim 12, **characterized in that** the bezels hold PCBs (printed circuit boards) by the sides at the upper (71) and lower (72) part, which PCBs comprise the electronics and the electrical connections between the electronic components of the management system and the cells of the semi-modular block;
intermediate PCBs (12, 13, Fig. 1) are arranged vertically between the cells in a direction perpendicular to the direction S comprise at least the heating resistors of the semi-modular assembly and these resistors are connected on demand from the management circuit to a power supply;
the PCB part (6) arranged under the cells contributes to recovering the potentials of each of the cells of the semi-modular block to supply them to the voltage management and balancing circuit of the semi-modular block management system.

14. High-current battery pack (1) according to claim 12 or 13, **characterized in that** resistors are mounted between two contact pads (not shown) on the upper (4, 4') and/or lower (6) PCBs and the contact with the cells and the tracks of the upper or lower printed circuit boards are made by elastic pins, or conical coil springs, for example, arranged between the cells and the conductive face comprising the contact pads of the printed circuit board, thus avoiding the use of tin solder.

15. High-current, semi-modular battery pack (1) according to one of claims 12 to 14, **characterized in that** the vertical central board (13) comprises temperature sensors and a thermostat.

16. High-current, semi-modular battery pack (1) according to one of claims 12 to 15, **characterized in that** the board (5) comprising the management system (BMS, 3) is arranged vertically on the side of the battery pack (1) so as to form a U with the other PCBs (4, 6) of said pack.
